# EUROPEAN PATENT SPECIFICATION

(11) **EP 0 670 592 B1**
(45) Date of publication and mention of the grant of the patent: **05.11.2003**
(21) Application number: 95301369.5
(22) Date of filing: 03.03.1995
(51) Int. Cl.: H01L 21/331, H01L 29/04, H01S 5/32, H01L 21/335, H01L 21/205

(54) **Semiconductor devices and their manufacture utilizing crystal orientation dependence of doping**
Halbleitervorrichtungen sowie ihre Herstellung unter Verwendung der Kristallorientierungsabhängigheit der Datierungs
Dispositifs semi-conducteurs et leur fabrication utilisant la dépendance cristalline du dopage quant à l'orientation

(30) Priority: 04.03.1994 JP 3488394
(43) Date of publication of application: 06.09.1995
(73) Proprietor: FUJITSU LIMITED, Kawasaki-shi, Kanagawa 211 (JP)
(72) Inventor: Kondo, Makoto, c/o Fujitsu Ltd., Kawasaki-shi, Kanagawa 211 (JP); Anayama, Chikashi, c/o Fujitsu Ltd., Kawasaki-shi, Kanagawa 211 (JP); Shoji, Hajime, c/o Fujitsu Ltd., Kawasaki-shi, Kanagawa 211 (JP)
(74) Representative: Silverman, Warren

(56) References cited:
- DE-A- 3 728 524
- US-A- 4 839 307
- US-A- 4 932 033
- JOURNAL OF CRYSTAL GROWTH, vol. 118, no. 3/4, 1 April 1992 NL, pages 467-469, C.CANEAU ET AL. 'DEPENDENCE OF DOPING ON SUBSTRATE ORIENTATION FOR GAAS:C GROWN BY OMVPE'
- ELECTRONICS LETTERS, vol. 26, no. 11, 24 May 1990 US, pages 724-725, F.REN ET AL. 'GAAS-ALGAAS HBT WITH CARBON DOPED BASE LAYER GROWN BY MOMBE'
- APPLIED PHYSICS LETTERS, vol. 50, no. 17, 27 April 1987 US, pages 1149-1151, K.TAMAMURA ET AL. 'CARBON INCORPORATION IN METALORGANIC CHEMICAL VAPOR DEPOSITION (AL,GA)AS '
- IEEE ELECTRON DEVICE LETTERS, vol. 13, no. 1, January 1992 US, pages 29-31, W.Q.LI ET AL. 'MOLECULAR BEAM EPITAXIAL GAAS/ALGAAS HETEROJUNCTION BIPOLAR TRANSISTORS ON (311)A GAAS SUBSTRATES WITH ALL-SILICON DOPING '
- APPLIED PHYSICS LETTERS, 15 DEC. 1985, USA, vol. 47, no. 12, ISSN 0003-6951, pages 1309-1311, MILLER D L 'Lateral p-n junction formation in GaAs molecular beam epitaxy by crystal plane dependent doping'
- SEVENTH INTERNATIONAL CONFERENCE ON METALORGANIC VAPOR PHASE EPITAXY, YOKOHAMA, JAPAN, 31 MAY-3 JUNE 1994, vol. 145, no. 1-4, ISSN 0022-0248, JOURNAL OF CRYSTAL GROWTH, DEC. 1994, NETHERLANDS, pages 390-396, KONDO M ET AL 'Dependence of carbon incorporation on crystallographic orientation during metalorganic vapor phase epitaxy of GaAs and AlGaAs'

## Description

The present invention relates to group III-V compound semiconductor devices and their manufacture and, more especially, is concerned with doping techniques for doping epitaxial layers during the manufacture of such devices.

Conventional compound semiconductor devices are most commonly formed on a flat substrate, most especially a substrate having. a flat surface aligned with the crystallographic (1 0 0) plane. Semiconductor crystal structures of GaAs, InP or other compound semiconductors can be epitaxially grown with excellent quality, and relatively easily, on such (1 0 0) plane substrates. Moreover, (1 0 0) wafers can be easily cleaved to form fine or minute semiconductor devices.

Recently, the manufacture of semiconductor devices by epitaxially growing a semiconductor crystal on a semiconductor substrate having not only a (1 0 0) plane surface but also surfaces of other crystal orientations has been studied. Growth on substrates having steps, grooves or ridges has also been studied. It is expected that semiconductor devices having excellent performance difficult to be realized on a (1 0 0) plane substrate can be manufactured by using substrates having surfaces or crystal orientations other than the (1 0 0) plane as well as steps, grooves or ridges.

It is an important technique of semiconductor device manufacture to control the conductivity type and carrier concentration of a semiconductor crystal by doping impurities. It is therefore important to have a knowledge of crystal orientation dependence of p-type or n-type impurity doping in a crystal epitaxially grown on a semiconductor substrate.

The inventors have previously studied the crystal orientation dependence of the doping characteristics of dopants in group III-V compound semiconductors grown by metal organic vapour phase epitaxy (MOVPE), by using dopants such as group II acceptors (Zn and Mg), group VI donors (Se) and group IV donors (Si). For details, reference is made to Kondo, *et al*, "Crystal orientation dependence of impurity dopant incorporation in MOVPE-grown III-V materials", J. Crystal Growth, vol. 124, p.449 (1992).

The crystal orientation dependence of the doping characteristics of silicon with molecular beam epitaxy (MBE) has also been studied. See for example: D.L. Miller, Applied Physics Letters, vol. 47, pages 1309-1311 (1985); US-A-4839307; US-A-4932033; and Li *et al*, IEEE Electron Device Letters, vol. 13, pages 29-31 (1992).

For both MBE and MOVPE growth, carbon has generally been considered to be a contaminant, residual amounts of which are a limiting factor on carrier mobility in compound semiconductor devices. It is known from DE-A-3728524, and a corresponding article by Tamamura *et al* in Applied Physics Letters, vol. 150, lines 1149-1151 (1987), that carbon incorporation during MOVPE growth of GaAs and AlGaAs can be reduced by using (311)B oriented and terminated substrates instead of (100) oriented substrates. In this work, (311)A oriented and terminated substrates were also studied and it was found that carbon incorporation levels were higher than for (311)B substrates.

Carbon as an intentional dopant has also received some attention. Ren *et al* in Electronics Letters, vol. 26, pages 724 and 725 (1990) used carbon as a p-type dopant of GaAs with metal organic molecular beam epitaxy (MOMBE) using trimethylgallium (TMGa) as a source.

Intentional carbon doping with MOVPE using carbon tetrachloride (CCl₄) as a source has been studied in GaAs by Caneau *et al*, J. Crystal Growth, vol. 118, pages 467 - 469 (1992) for the following substrate orientations and terminations: (100); (111)A; (211)A; (211)B; (311)A; and (311)B. In this study carbon was a p-type dopant for all substrate orientations and terminations. Moreover, it was found that carbon incorporation was greater on "A" terminated faces than "B" terminated faces, i.e. layers grown on "A" faces were more strongly p-type than those grown on "B" faces.

According to a first aspect of the invention there is provided a method of manufacturing a semiconductor device, the method comprising the steps of:
preparing a substrate, made of a group III-V compound semiconductor containing arsenic as a group V element, to have a stepped surface containing first and second planes of different respective crystal orientations, said first and second planes having different carbon capture cross-sections in respect of at least one epitaxial layer to be formed on the surface of said stepped substrate using carbon as a dopant impurity; and
epitaxially growing at least one group III-V compound semiconductor layer, containing arsenic as a group V element, on said stepped substrate using metal organic vapour phase epitaxy (MOVPE) while doping with carbon as a dopant impurity under such conditions that the or each epitaxial layer thus grown has different conductivity types on said first and second planes, said epitaxial growth step involving epitaxially growing said group III-V compound semiconductor using an organic metal compound containing carbon as a group III source material while controlling the partial pressure ratio between the group III source material and a group V source material so as to make the or each epitaxial layer thus grown p-type on one of said first and second planes and n-type on the other of said first and second planes.

The method of the first aspect of the invention can be applied to manufacture novel semiconductor devices on structured surfaces including facets of crystal orientation other than (1 0 0), the structure taking the form of steps, grooves, ridges or other non-planar surface features.

The selective doping may be achieved with carbon alone as above, or with carbon in conjunction with a dopant impurity which dopes n-type over the whole growth surface, for example silicon, sulphur or selenium. In both cases, the crystal orientation dependence of the carbon capture cross-section is exploited to grow an epitaxial layer with both n- and p-type regions.

According to a second aspect of the present invention there is provided a method of manufacturing a semiconductor device, the method comprising the steps of:
preparing a substrate, made of a group III-V compound semiconductor containing arsenic as a group V element, to have a stepped surface containing first and second planes of different respective crystal orientations, said first and second planes having different carbon capture cross-sections in respect of at least one epitaxial layer to be formed on the surface of said stepped substrate using carbon as a dopant impurity; and
epitaxially growing at least one group III-V compound semiconductor layer, containing arsenic as a group V element, on said stepped substrate using metal organic vapour phase epitaxy (MOVPE) while doping with at least carbon as a dopant impurity, said carbon being a p-type dopant for both said first and second planes and having a first concentration when situated over one of said first and second planes and a second, different concentration when situated over the other of said first and second planes, and doping, at the same time or in a different doping step, with a further dopant impurity, said further dopant impurity being an n-type dopant for both said first and second planes and having a third concentration between said first and second concentrations, said third concentration being high enough to compensate the lower of said first and second concentrations, but not high enough to compensate the higher of said first and second concentrations, such that the or each epitaxial layer thus grown has different conductivity types on said first and second planes, said epitaxial growth step involving epitaxially growing said group III-V compound semiconductor using an organic metal compound containing carbon as a group III source material while controlling the partial pressure ratio between the group III source material and a group V source material so as to make the or each epitaxial layer thus grown p-type on one of said first and second planes and n-type on the other of said first and second planes.

These two methods can be used to manufacture a semiconductor device of the kind comprising:
a substrate made of a group III-V compound semiconductor, containing arsenic as a group V element, and having a stepped surface containing first and second planes of different respective crystal orientations; and
at least one epitaxial layer of a group III-V compound semiconductor, containing arsenic as a group V element, arranged on the stepped surface.

According to a third aspect of the invention a device of the above-mentioned kind is characterised in that:
the or each epitaxial layer contains carbon as a dopant impurity, the carbon in the or each epitaxial layer being incorporated as an n-type dopant impurity where situated over one of said first and second planes of the substrate and as a p-type dopant impurity where situated over the other of said first and second planes, so that the or each epitaxial layer has regions of opposite conductivity type across its lateral extent.

According to a fourth aspect of the invention, a device of the above-mentioned kind is characterised in that:
the or each epitaxial layer contains carbon as a p-type dopant impurity and a further element as an n-type dopant impurity, the carbon in the or each epitaxial layer being present at a first concentration where situated over one of said first and second planes of the substrate and a second concentration, different from the first concentration, where situated over the other of said first and second planes, and the further element in the or each epitaxial layer being present at a third concentration, between the first and second concentrations, where situated over both the first and second planes, said third concentration being high enough to compensate the lower of said first and second concentrations, but not high enough to compensate the higher of said first and second concentrations so that the or each epitaxial layer has regions of opposite conductivity type across its lateral extent.

It will thus be understood that an epitaxial layer having p-type and n-type regions can be formed, the doping type depending upon the crystal orientation of the growth surface under the part of the layer concerned, by using a group III source material containing carbon and selecting an appropriate V/III ratio. Thus, it is possible to form a p- or n-type region in self-alignment with the configuration of a structured substrate. It is therefore possible for example to form a semiconductor laser with a self-aligned current blocking region.

In this specification, the plane defined by using "about i" includes the plane defined by "i" and other planes tilted therefrom by +/-5°.

For a better understanding of the invention, and to show how the same may be carried into effect, reference will now be made, by way of example, to the accompanying drawings, in which:-
Fig. 1 is a graph showing the crystal orientation and termination dependence of carbon concentration and carrier concentration in GaAs epitaxial layers formed by MOVPE;
Fig. 2 is a graph showing the crystal orientation and termination dependence of carbon concentration and carrier concentration in AlGaAs epitaxial layers formed by MOVPE;
Fig. 3 is a graph showing the V/III source ratio dependence of carrier concentration in GaAs epitaxial layers formed by MOVPE;
Figs. 4, 5A and 5B are cross-sectional views of substrates illustrating the selective formation of n-type and p-type regions by exploiting the fact that the carrier type varies with the V/III source ratio and crystal orientation and termination;
Fig. 6 is a graph showing the crystal orientation and termination dependence of silicon concentration and carrier concentration in GaAs epitaxial layers formed by MOVPE;
Fig. 7 is a graph showing the crystal orientation and termination dependence of carbon concentration, silicon concentration and carrier concentration in GaAs epitaxial layers formed by MOVPE;
Figs. 8A to 8C are cross-sectional views of substrates illustrating the selective formation of n-type and p-type regions by exploiting the different crystal orientation and termination dependencies of carbon and silicon incorporation;
Fig. 9 is a graph showing a crystal orientation dependence of carbon concentration, selenium concentration and carrier concentration in GaAs epitaxial layers formed by MOVPE;
Figs. 10A and 10B are cross-sectional views of substrates illustrating the selective formation of n-type and p-type regions by exploiting the different crystal orientation and termination dependencies of carbon and selenium incorporation;
Fig. 11 is a cross-sectional view of a semiconductor laser according to a first embodiment of the invention;
Fig. 12 is a cross-sectional view of a semiconductor laser according to a second embodiment of the invention;
Fig. 13 is a cross-sectional view of a semiconductor laser according to a third embodiment of the invention; and
Figs. 14A and 14B are a cross-sectional view and a perspective view of a semiconductor laser according to a fourth embodiment of the invention.

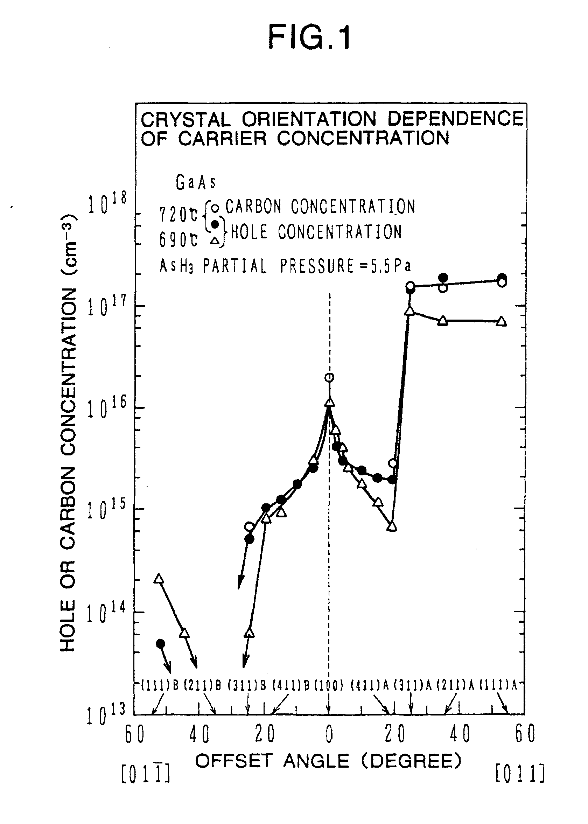

Fig. 1 is a graph showing crystal orientation dependence of carbon concentration and hole concentration of carbon-doped GaAs epitaxial layers grown by MOVPE. The abscissa represents the offset angle of the plane of a GaAs substrate from a (1 0 0) plane. The centre of the abscissa is a (1 0 0) plane, the right side from the centre shows an offset angle of the substrate tilted towards the [0 1 1] direction, and the left side from the centre shows an offset angle of the substrate tilted towards the [0 1 -1] direction. That is to say, the right side half of Fig. 1 shows "A" terminated planes and the left side half shows "B" terminated planes. Typical low Miller indices planes are also shown at respective corresponding offset angles in Fig. 1. The ordinate represents carbon or hole concentration in units of cm⁻³.

Epitaxial layers were grown under a pressure of 6.6 x 10³ Pa and an AsH₃ partial pressure of 5.5 Pa by using trimethyl gallium (TMGa) as the group III source material and arsine (AsH₃) as the group V source material. In Fig. 1, an open circle symbol represents carbon concentration and a solid circle symbol represents hole concentration for epitaxial layers grown at a substrate temperature of 720°C. An open triangle symbol represents hole concentration, with the epitaxial layer grown at a substrate temperature of 690°C. The carbon concentration was measured by secondary ion mass spectrometry and the hole concentration was measured from a C-V characteristic curve. Since the carbon and hole concentration values are generally equal, it can be understood that carbon atoms captured in the crystal are almost perfectly ionized (activated).

As seen from Fig. 1, as the substrate surface is tilted in the [0 1 1] direction towards an offset angle of about 20°, i.e. in the range from the (1 0 0) plane to the (4 1 1)A plane, the hole concentration gradually lowers as the offset angle increases. As the offset angle is further increased towards about 25°, i.e. the (3 1 1)A plane, the hole concentration increases abruptly, to a level about ten times higher than that achieved at the (1 0 0) plane. The hole concentration then scarcely changes as the offset angle is further increased from the (3 1 1)A plane.

As the substrate surface is tilted in the [0 1 -1] direction towards an offset angle of about 25°, i.e. in the range from the (1 0 0) plane to the (3 1 1)B plane, the hole concentration gradually lowers as the offset angle increases, similar to the A plane tilt. The hole concentration takes a minimum value at an offset angle between the (3 1 1)B plane and the (2 1 1)B plane. As the offset angle is further increased, the hole concentration changes to have a higher value.

The crystal orientation dependence of hole concentration has a similar tendency at both studied substrate temperatures, i.e. at 720° and 690°. The hole concentration and the carbon concentration are generally equal. The crystal orientation dependence of the hole concentration is therefore considered to reflect that of the carbon concentration. As seen from the above, the concentration of captured carbon atoms greatly depends upon the crystal orientation. The above experiments first revealed such complicated dependence. Moreover, the results shown in Fig. 1 do not agree either qualitatively or quantitatively with the previous results of Caneau *et al* referred to in the introduction.

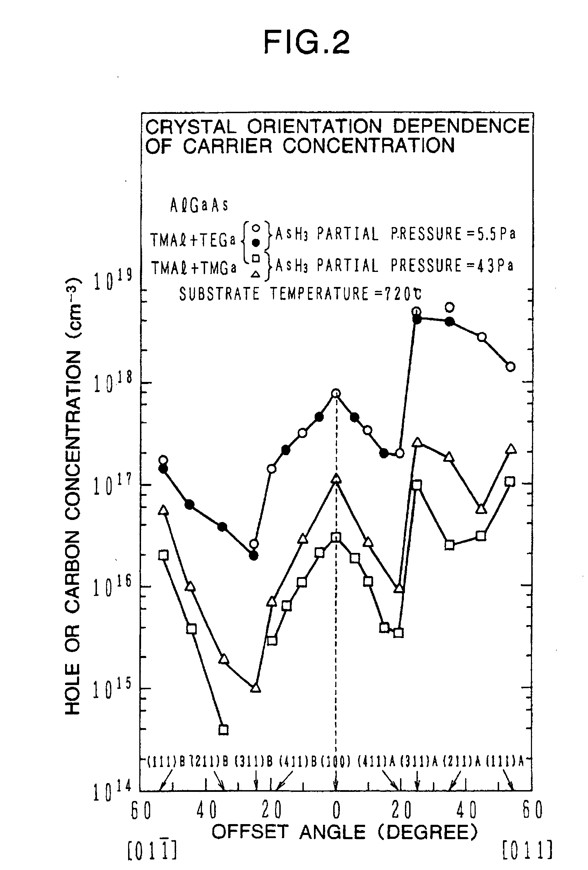

Fig. 2 is a graph showing a crystal orientation dependence of carbon concentration and hole concentration of carbon-doped AlₓCa₁₋ₓAs (x = 0.3) epitaxial layers grown by MOVPE. Like Fig. 1, the abscissa and the ordinate represent offset angle and the hole or carbon concentration respectively.

Epitaxial layers were grown under a pressure of 6.6 x 10³ Pa and a substrate temperature of 720°C by using trimethyl aluminium (TMAl), and TMGa or triethyl gallium (TEGa) as the group III source material and arsine (AsH₃) as the group V source material. In Fig. 2, an open circle symbol represents carbon concentration. A solid circle symbol, an open square symbol and an open triangle symbol represent hole concentration. Use of TEGa as the gallium source material pertains to the open circle symbol, solid circle symbol and open square symbol, whereas use of TMGa as the gallium source material pertains to the open triangle symbol. An AsH₃ partial pressure of 5.5 Pa pertains to the open circle symbol and solid circle symbol, and that of 43 Pa pertains to the open square symbol and open triangle symbol.

Similar to Fig. 1, as the offset angle increases in the range from the (1 0 0) plane to the (4 1 1)A plane, the hole concentration gradually lowers. As the offset angle is further increased to about 25°, i.e. towards the (3 1 1)A plane, the hole concentration increases abruptly.

As the substrate surface is tilted in the [0 1 -1] direction in the range from the (1 0 0) plane to the (3 1 1)B plane, the hole concentration gradually lowers as the offset angle increases. As the offset angle is further increased, the hole concentration changes to have a higher value.

A change in the hole concentration with the offset angle from the (100) plane of the substrate has a similar tendency both for TEGa and TMGa used as the gallium source material. A change in the hole concentration with the offset angle has a similar tendency both for the AsH₃ partial pressures of 5.5 Pa and 43 Pa, although the former pressure indicates a higher hole concentration than the latter pressure.

Such a crystal orientation dependence of hole concentration can be used in manufacturing various types of semiconductor devices. For example, it can be seen that if p-type impurities are desired to be doped at a high concentration, it is preferable to use a plane in the range from the (3 1 1)A plane to the (1 1 1)A plane rather than to use the (1 0 0) plane. Conversely, if contamination by carbon impurities is desired to be suppressed as much as possible, it can be seen that it is more preferable to use a plane in the range from the (4 1 1)A plane to the plane near the (5 1 1)A plane or a plane in the range from the (3 1 1)B plane to the plane near the (2 1 1)B plane, than the (1 0 0) plane.

As seen from Fig. 1, use of a substrate having a crystal orientation tilted from the (1 0 0) plane toward the (1 1 1)B plane allows the amount of carbon dopant incorporation to be lower than if the (1 0 0) plane is used. When the offset angle from the (1 0 0) plane is about 35° or larger, the surface conditions of the substrate become bad. It is therefore preferable to set the offset angle to 35° or smaller. A plane, such as a (4 1 1)A plane, tilted by an angle in the range larger than 0° and smaller than 25°, from the (1 0 0) plane to the (1 1 1)A plane, may also be used which provides a small carbon capture cross-section. Material containing arsenic such as InGaAs may be used for the electron transfer layer, with similar advantageous effects being ensured by an appropriate selection of crystal orientation and surface termination.

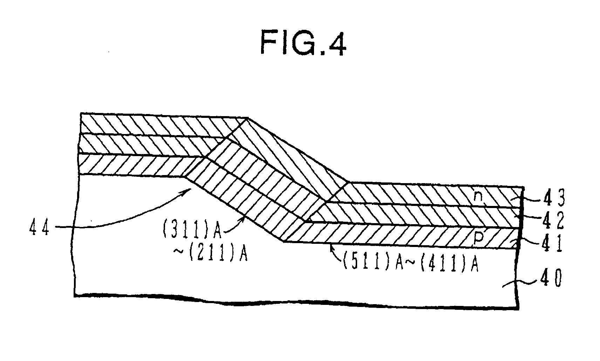

From the above description of Figs. 1 and 2 it is apparent how the level of p-type doping of GaAs and AlGaAs varies with crystal orientation. In the following description of Figs. 4 to 10 it will now be explained how it is also possible to grow either p-type or n-type material under the same growth conditions depending on the crystal orientation.

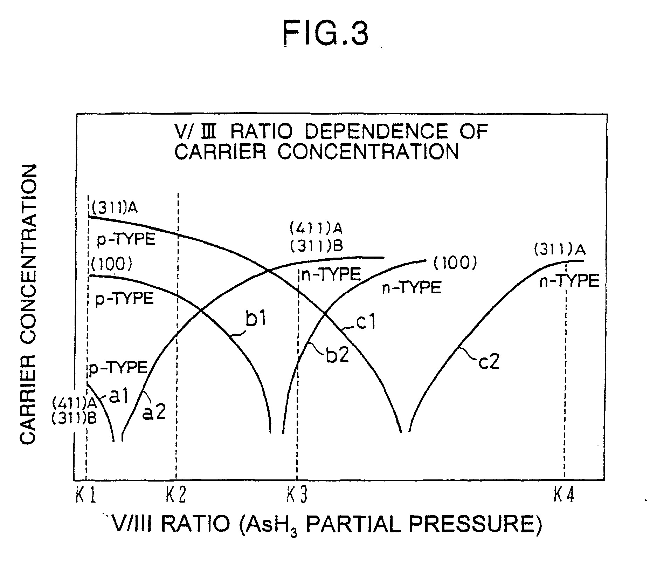

Fig. 3 is a graph showing the change in carrier concentration in a carbon-doped GaAs layer formed by MOVPE relative to V/III source ratio or AsH₃ partial pressure. The abscissa represents V/III source ratio or AsH₃ partial pressure in an arbitrary scale. The ordinate represents carrier concentration in an arbitrary scale.

Curves "a1", "b1" and "c1" represent hole concentrations in carbon-doped GaAs layers formed on substrates respectively having a (3 1 1)B plane or a (4 1 1)A plane, a (1 0 0) plane and a (3 1 1)A plane. Curves "a2", "b2" and "c2" represent corresponding electron concentrations.

As shown in Fig. 3, as the V/III ratio increases, the capture of carbon elements is suppressed and the hole concentration reduces for each of the substrate crystal orientations and terminations. In each case, at a certain V/III ratio, the conductivity type is inverted from p-type to n-type and the electron concentration increases. The V/III ratio at which the switch from p-type to n-type occurs is different for each substrate crystal orientation and termination.

The V/III ratio at which the carrier type changes over from p-type to n-type increases in the order: (3 1 1)B plane or (4 1 1)A plane; (1 0 0) plane; and (3 1 1)A plane. By utilising the fact that the V/III ratio at which the changeover from p-type to n-type occurs is different for different crystal orientations, it becomes possible to pattern and form both p-type and n-type regions by the same film forming process on a substrate having a plurality of surfaces of different planes of crystal orientation. In the following, an example of patterning a p-type region and an n-type region on a substrate by utilizing such characteristics will be described.

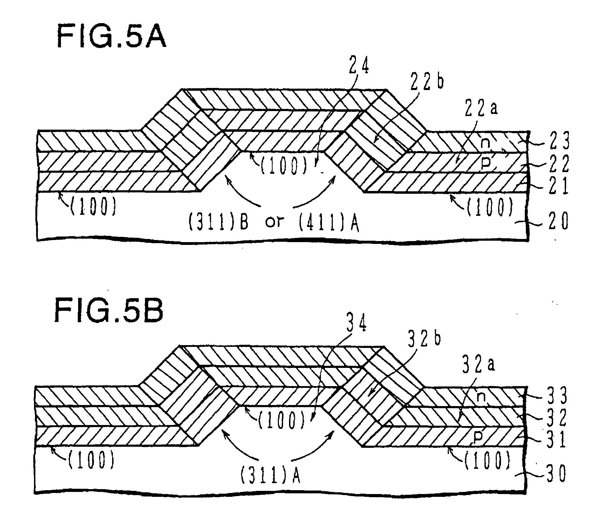

As shown in Fig. 5A, on a (1 0 0) GaAs substrate 20, a ridge 24 is formed which has a flat surface of the (1 0 0) plane and slanted surfaces of a (3 1 1)B plane, a (4 1 1)A plane, or another plane having a carbon capture cross-section smaller than the (1 0 0) plane.

The ridge 24 may be formed by wet etching using a resist mask. The slanted surface formed by wet etching is not a surface having a single crystal orientation but contains other surfaces near the (3 1 1)B plane or (4 1 1)A plane. These surfaces are considered to have properties similar to the (3 1 1)B plane or (4 1 1)A plane. In the following, although the flat surface and slanted surfaces are each described to have a single crystal orientation, it is intended that they may have other crystal orientations having similar properties.

Epitaxial growth is performed first with a V/III ratio of K1, as shown in Fig. 3, so that a p-type epitaxial layer 21 is formed on the whole surface of the substrate 20. Next, epitaxial growth is performed with an increased V/III ratio of K2, so that an epitaxial layer 22 is formed which has a p-type region on the flat surfaces of the (1 0 0) planes and an n-type region on the slanted surfaces of the (3 1 1)B or (4 1 1)A planes. An epitaxial layer having a stripe-shaped n-type region 22b between p-type regions 22a can thus be formed by a single film forming process. Epitaxial growth is then performed at a further increased V/III ratio of K4, so that an n-type epitaxial layer 23 is formed on the whole surface of the substrate.

As will be appreciated, the p-type epitaxial layer 21 grown with a V/III ratio of K1 has different hole concentrations at the regions under the flat surface and the regions under the slanted surface, the hole concentration under the flat surfaces being higher than that under the slanted surfaces.

In Fig. 5A, a slanted surface having a (3 1 1)B plane or (4 1 1)A plane is used. A slanted surface having an (n 1 1)B plane, where n is a real number of about 1 ≤ n, or a (m 1 1)A plane, where m is a real number of about m = 4, may also be used.

Fig. 5B shows a semiconductor device having a ridge with the slanted surface of a (3 1 1)A plane.

As shown in Fig. 5B, on a (100) GaAs substrate 30, a ridge 34 is formed which has a flat surface of the (1 0 0) plane and slanted surfaces of a plane such as a (3 1 1)A plane having a carbon capture cross-section larger than the (1 0 0) plane.

Epitaxial growth is performed first with a V/III ratio of K1 or K2, as shown in Fig. 3, so that a p-type epitaxial layer 31 is formed on the whole surface of a substrate 30. Next, epitaxial growth is performed at an increased V/III ratio of K3, so that an epitaxial layer 32 is formed which has n-type regions on the flat surfaces of the (1 0 0) planes and p-type regions on the slanted surfaces of the (3 1 1)A planes. Therefore, an epitaxial layer having a stripe-shaped p-type region 32b between n-type regions 32a can be formed by a single film forming process. Further epitaxial growth is performed at a further increased V/III ratio of K4, so that an n-type epitaxial layer 33 is formed on the whole surface of the substrate.

Fig. 4 shows a semiconductor device having carbon-doped layers formed on a substrate 40 having flat surfaces exposing a plane in the range from a (5 1 1)A plane to a (4 1 1)A plane and a slanted surface exposing a plane in the range from a (3 1 1)A plane to a (2 1 1)A plane.

Epitaxial growth is performed first with a V/III ratio of K1 as shown in Fig. 3, so that a p-type epitaxial layer 41 is formed on the whole surface of a substrate 40. Next, epitaxial growth is performed at an increased V/III ratio of K2 or K3, so that an epitaxial layer 42 is formed which has n-type regions on the flat surfaces and a p-type region on the slanted surface. An epitaxial layer having a stripe-shaped p-type region between n-type regions can thus be formed by a single film forming process. Epitaxial growth is performed at a further increased V/III ratio of K4, so that an n-type epitaxial layer 43 is formed on the whole surface of the substrate.

In the above, a GaAs layer is epitaxially grown. Instead of a GaAs layer, other group III-V compound semiconductor layers such as AlGaAs may be used so long as they contain arsenic as the group V element. Also in such a case, a layer having n-type and p-type regions can be patterned by using planes of different crystal orientation.

The flat surface may have a plane in the range from a (1 1 1)A plane to a (3 1 1)A plane which has a carbon capture cross-section at least approximately equal to or larger than that of a (1 0 0) plane. The slanted surface may have an (n 1 1)A plane, where n is a real number of about 4 ≤ n, having a carbon capture cross-section smaller than that for orientations between the (1 1 1)A plane and the (3 1 1)A plane.

In the above, carbon is doped by using metallo organic compounds containing carbon as the group III source material. A doping source of only carbon may be used to change the carbon doping concentration with similar advantageous effects described above. Furthermore, in the above embodiments, a ridge of a simple shape is used. Instead, a ridge, a groove, a step, or the like, of a desired shape may be used to pattern p-type and n-type regions of the desired shape.

Next, it will be described how to form p- and n-type regions in a single epitaxial layer not by doping solely with carbon, as described above, but by doping with carbon in conjunction with one or more other elements.

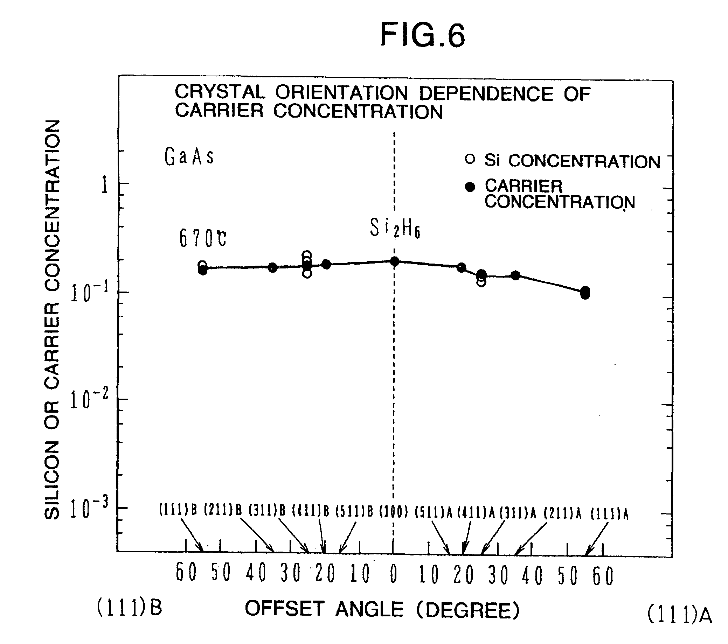

Fig. 6 is a graph showing the crystal orientation dependence of silicon concentration in a silicon-doped GaAs layer formed by MOVPE. The growth temperature of the GaAs layers was 670°C and the doping gas used was disilane (Si₂H₆). Similar to Fig. 1, the abscissa represents an offset angle from a (1 0 0) plane, the right half of Fig. 6 represents "A" terminated surfaces and the left half thereof represents "B" terminated surfaces. The ordinate represents carrier or silicon concentration in an arbitrary scale. An open circle symbol indicates silicon concentration and a solid circle symbol indicates carrier concentration.

As shown in Fig. 6, the silicon concentration and the carrier concentration are generally equal and scarcely depend on the crystal orientation of a substrate. Even if monosilane (SiH₄) is used as the doping gas, silicon doping has a crystal orientation and termination dependence considerably smaller than that of carbon. There is a crystal orientation dependence more or less comparable with that of disilane.

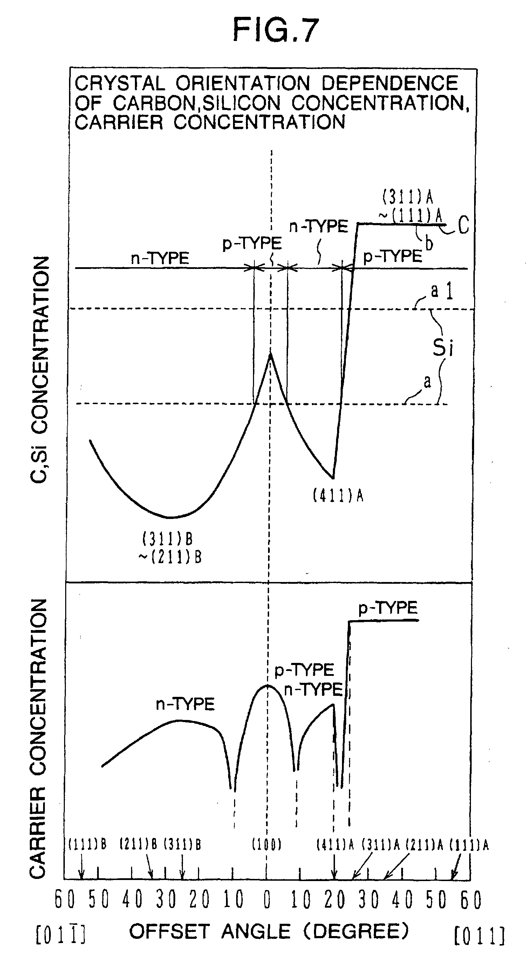

The upper diagram in Fig. 7 is formed by superposing Fig. 1 of the carbon concentration upon Fig. 6 of the silicon concentration. A curve "b" indicates the carbon concentration and broken lines "a" and "a1" indicate the silicon concentration. The broken line "a" indicates epitaxial growth under the conditions that the silicon dopant concentration is smaller than the carbon dopant concentration at the (1 0 0) plane and larger than the carbon dopant concentration at the (4 1 1)A plane. The broken line "a1" indicates epitaxial growth under the conditions that the silicon dopant concentration is larger than the carbon dopant concentration at the (1 0 0) plane and smaller than the carbon dopant concentration at the (3 1 1)A plane.

The lower diagram in Fig. 7 shows crystal orientation and termination dependence of carrier concentration when both carbon and silicon are doped under the silicon doping conditions of the broken line "a" and the carbon doping conditions of the line "b". Silicon becomes an n-type impurity by substituting a group III element and carbon becomes a p-type impurity by substituting a group V element. Therefore, a layer grown on the surface of a substrate having a plane near a (1 0 0) plane becomes p-type because the carbon dopant concentration is larger than the silicon dopant concentration.

As the offset angle of a substrate departs from the (1 0 0) plane, the carbon dopant concentration reduces and approaches the silicon dopant concentration. The hole concentration therefore reduces. As the offset angle further increases, the carbon dopant concentration becomes smaller than the silicon concentration. As a result, electrons become the majority carriers and the conductivity type becomes n-type.

As the offset angle increases in the [0 1 1] direction to reach the (4 1 1)A plane, the carbon concentration reduces more and the electron concentration increases. As the offset angle increases to the (3 1 1)A plane, the carbon concentration increases abruptly and becomes equal to or more than the silicon concentration. Therefore, the conductivity type becomes p-type again and the hole concentration becomes higher than that in the layer formed on the (1 0 0) plane.

As the offset angle increases in the [0 1 -1] direction, the carbon concentration gradually reduces and takes a minimum value at a plane between the (3 1 1 1)B plane and the (2 1 1)B plane. Therefore, as the offset angle increases, the electron concentration gradually increases and takes a maximum value at the plane between the (3 1 1)B plane and the (2 1 1)B plane.

By doping carbon and silicon under appropriate doping conditions, it therefore becomes possible to control the conductivity type and the carrier concentration of an epitaxial layer in accordance with the crystal orientation of the substrate. It is therefore possible epitaxially to grow p- and n-type regions by doping both silicon and carbon at the same time during the growth of a layer on a surface having parts of different crystal orientations.

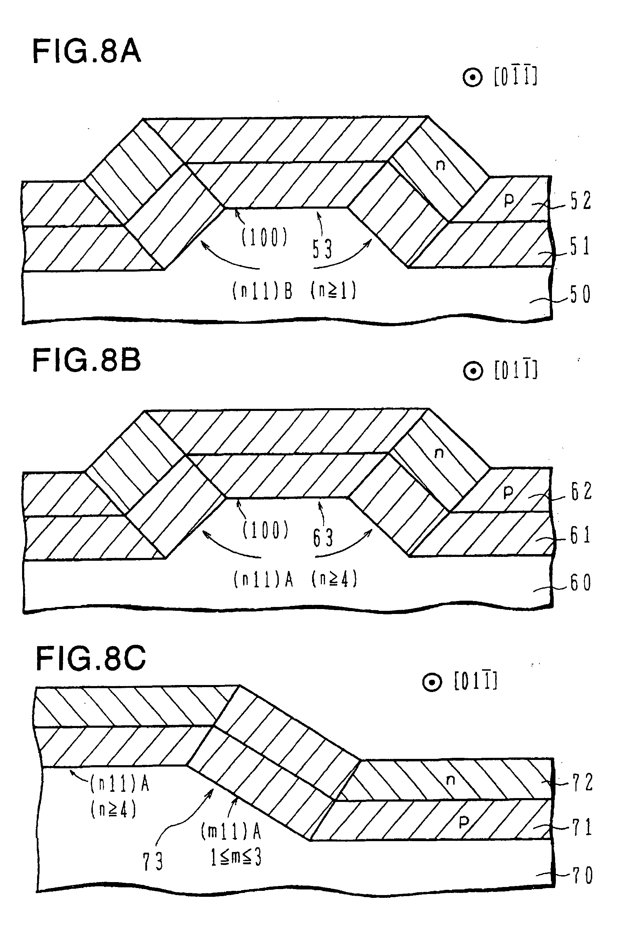

Figs. 8A to 8C show examples of semiconductor devices having p- and n-type regions on the surfaces of substrates selectively formed by doping carbon and silicon at the same time.

Fig. 8A shows an example utilizing the effect that a p-type region is formed on surfaces having a plane near a (1 0 0) plane and an n-type region is formed on surfaces having a plane near an (n 1 1)B plane, where n is a real number of about 1 ≤ n. On the surface of a substrate 50 having the (1 0 0) plane, a ridge 53 is formed having slanted surfaces of the (n 1 1)B plane, where n is a real number of about 1 ≤ n, extending in the [0 -1 -1] direction.

First, a p-type epitaxial layer 51 is formed on the whole surface of the substrate 50 by doping only carbon. The region under the slanted surface of the epitaxial layer 51 has a hole concentration smaller than the region under the flat surface, because of a smaller carbon capture cross-section.

Next, both carbon and silicon are doped at the same time under the conditions indicated by the broken line "a" shown in the upper drawing of Fig. 7. The region under the slanted surface has an n-type conductivity as seen from the lower drawing of Fig. 7. Therefore, an epitaxial layer 52 is formed having a p-type region under the flat surface and an n-type region under the slanted surface.

Fig. 8B shows an example utilizing the effect that a p-type region is formed on surfaces having a plane near a (1 0 0) plane and an n-type region is formed on surfaces having a plane near a (n 1 1)A plane, where n is a real number of about 4 ≤ n. On the surface of a substrate 60 having the (1 0 0) plane, a ridge 63 is being formed having slanted surfaces of the (n 1 1)A plane, where n is a real number of about 4 ≤ n, extending in the [0 1 -1] direction.

First, a p-type epitaxial layer 61 is formed on the whole surface of the substrate 60 by doping only carbon. Next, by doping both carbon and silicon at the same time, an epitaxial layer 62 is formed having a p-type region under the flat surface and an n-type region under the slanted surface.

Fig. 8C shows an example utilizing the effect that an n-type region is formed on surfaces having a (n 1 1)A plane, where n is a real number of about 4 ≤ n, and a p-type region is formed on surfaces having a (m 1 1)A plane, where m is a real number of about 1 ≤ m ≤ about 3. On the surface of a substrate 70 having the (n 1 1)A plane, where n is a real number of about 4 ≤ n, on its main surface, a step 73 is formed having a slanted surface of the (m 1 1)A plane, where m is a real number of about 1 ≤ m ≤ about 3, extending in the [0 1 -1] direction.

First, a p-type epitaxial layer 71 is formed on the whole surface of the substrate 70 by doping only carbon. Next, by doping both carbon and silicon at the same time, an epitaxial layer 72 is formed having an n-type region under the flat surface and a p-type region under the slanted surface.

Silicon is used as the n-type impurity in the cases shown in Figs. 6 and 7 and Figs. 8A to 8C. Other elements may also be used as the n-type impurity.

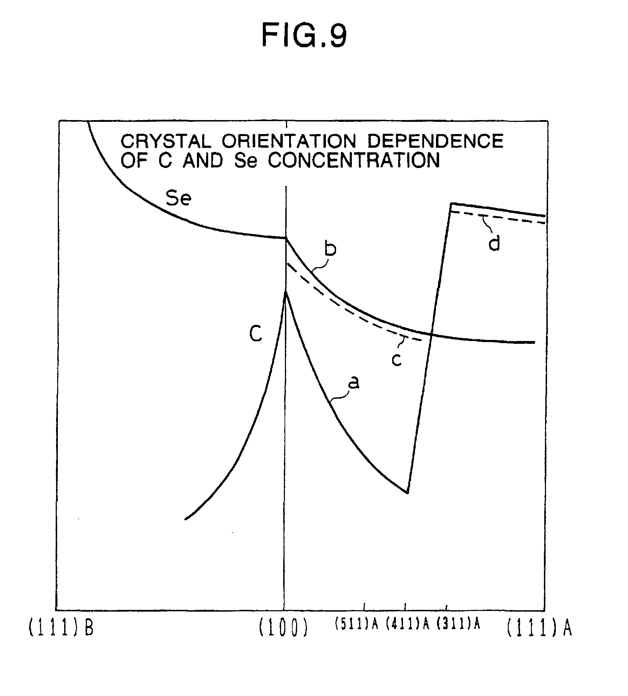

Fig. 9 is a graph showing a crystal orientation dependence of an impurity concentration in a GaAs layer epitaxially grown by using selenium as an n-type impurity. The abscissa represents crystal orientation and the ordinate represents impurity concentration and carrier concentration in an arbitrary scale. A curve "a" indicates carbon concentration and a curve "b" indicates selenium concentration. The crystal orientation dependence of the carbon concentration is the same as that shown in Fig. 1. The selenium concentration gradually reduces as the plane is tilted from the (1 0 0) plane to the (1 1 1)A plane. The epitaxial growth was performed under the conditions that the selenium concentration is higher than the carbon concentration at the (1 0 0) plane and (4 1 1)A plane and that the carbon concentration is higher than the selenium concentration at the (3 1 1)A plane.

Under the conditions shown in Fig. 9, the selenium concentration is higher than the carbon concentration in the range from the (1 0 0) plane to the (4 1 1)A plane and the conductivity type of an epitaxial layer becomes an n-type. The carbon concentration is higher than the selenium concentration in the range from the (3 1 1)A plane to the (1 1 1)A plane and the conductivity type of an epitaxial layer becomes a p-type. Therefore, the electron concentration gradually reduces as indicated by a curve "c" as the plane is tilted from the (1 0 0) plane to the (4 1 1)A plane. The hole concentration is nearly constant as indicated by a curve "d" in the range from the (3 1 1)A plane to the (1 1 1)A plane.

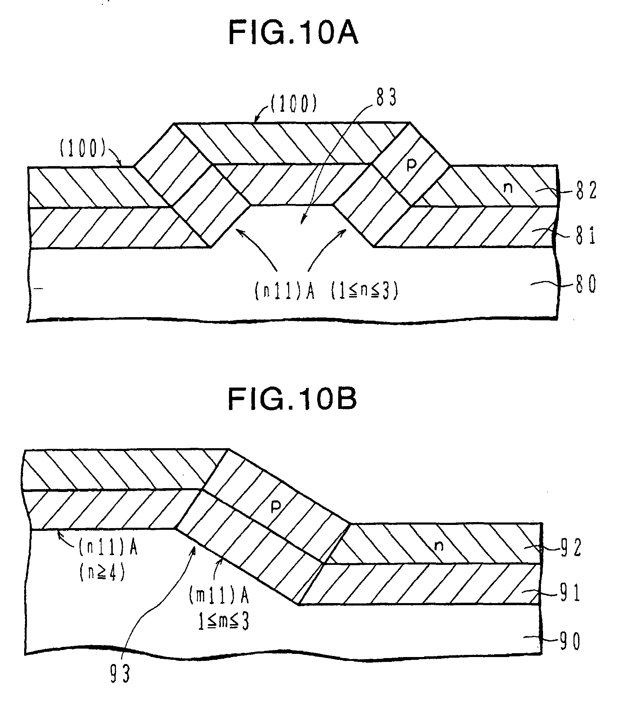

Figs. 10A and 10B show examples of semiconductor devices having p- and n-type regions in an epitaxial layer selectively formed by doping both carbon and selenium at the same time.

Fig. 10A shows an example utilizing the effect that an n-type region is formed on surfaces having a (1 0 0) plane and a p-type region is formed on surfaces having a plane oriented in the range from a (3 1 1)A plane to a (1 1 1)A plane. On the surface of a substrate 80 having the (1 0 0) plane, a ridge 83 is formed having slanted surfaces of a (n 1 1)A plane, where n is a real number of about 1 ≤ n ≤ about 3.

First, a p-type epitaxial layer 81 is formed on the whole surface of the substrate 80 by doping only carbon. Next, both carbon and selenium are doped at the same time epitaxially to grow an epitaxial layer 82 having an n-type region under the flat surface and a p-type region under the slanted surface.

Fig. 10B shows an example utilizing the effect that an n-type region is formed on surfaces having a (n 1 1)A plane, where n is a real number of about 4 ≤ n, and a p-type region is formed on surfaces having a plane oriented in the range from a (3 1 1)A plane to a (1 1 1)A plane. On the surface of a substrate 90 having the (n 1 1) plane, where n is a real number of about 4 ≤ n, on its main surface, a step 93 is formed having a slanted surface of a (m 1 1)A plane, where m is a real number of about 1 ≤ m ≤ about 3.

First, a p-type epitaxial layer 91 is formed on the whole surface of the substrate 90 by doping only carbon. Next, both carbon and selenium are doped at the same time to grow an epitaxial layer 92 having an n-type region under the flat surface and a p-type region under the slanted surface.

By doping carbon and selenium under appropriate conditions, n-type and p-type regions can be selectively formed. In Fig. 9 and Figs. 10A and 10B, selenium is used as the n-type impurity. Other group VI elements such as sulphur may also be used with similar advantageous effects.

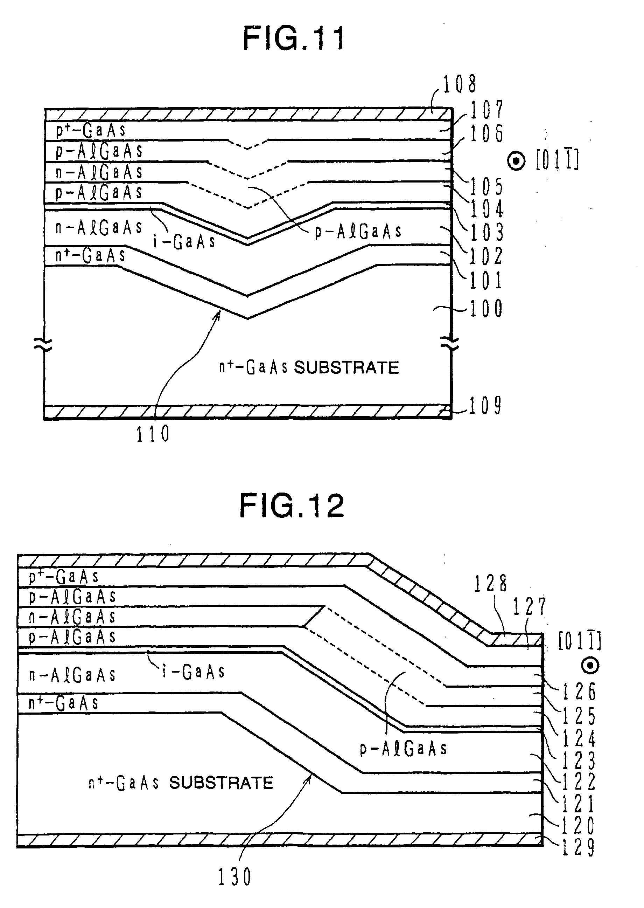

Several specific device structures which apply the principles of crystal-orientation dependent doping type described above will now be described with reference to Figs. 11 to 14.

First, an embodiment will be described with reference to Fig. 11 in which a semiconductor laser radiating a laser beam of 0.78 to 0.98 µm wavelength is formed by utilizing the dependence of carbon capture cross-section upon V/III ratio and crystal orientation, and the different crystal orientation dependencies of the capture cross-section of various impurities such as carbon, silicon and selenium.

Fig. 11 is a cross-sectional view of a semiconductor laser according to a first embodiment of the invention. The semiconductor laser of the first embodiment is formed by utilizing the difference between impurity capture cross-sections of the (1 0 0) and (3 1 1)A planes. On the surface of an n⁺- type GaAs substrate 100 having the (1 0 0) plane as its main surface, a groove 110 of a V-shape is formed having slanted surfaces of generally the (3 1 1)A plane and extending in the [0 1 -1] direction. Silicon is doped as the n-type impurity in the GaAs substrate 100 to an impurity concentration of 4 x 10¹⁸cm⁻³.

On the n⁺-type GaAs substrate 100, an n⁺-type GaAs buffer layer 101 is formed to a thickness of about 1.0 µm. Silicon is used as the n-type impurity dopant in the GaAs buffer layer 101 to an impurity concentration of 1 x 10¹⁸cm⁻³.

On the n⁺-type GaAs buffer layer 101, an n-type AlₓGa₁₋ₓAs clad layer (e.g. x = 0.3) 102 is formed to a thickness of about 2.0 µm. Silicon is used as the n-type impurity dopant in the AlGaAs clad layer 102 to an impurity concentration of 5 x 10¹⁷cm⁻³.

On the n-type clad layer 102, an undoped GaAs or AlₓGa₁₋ₓAs (e.g. x ≈ 0.1) active layer or a GaAs/InₓGa₁₋ ₓAs/GaAs (e.g. x ≈ 0.2) strained quantum well active layer 103 is formed.

On the active layer 103, a p-type AlₓGa₁₋ₓAs clad layer (e.g. x = 0.3) 104 is formed to a thickness of about 0.2 µm. Carbon is used as the p-type impurity dopant in the AlGaAs clad layer 104 to an impurity concentration of 1 x 10¹⁸cm⁻³.

On the p-type AlGaAs clad layer 104, a current blocking or confining AlₓGa₁₋ₓAs (e.g. x = 0.3) layer 105 is formed to a thickness of about 0.2 µm. The current confining layer 105 is formed by setting an appropriate V/III ratio as shown in Fig. 3 or by doping both carbon and silicon at the same time as shown in Fig. 7.

If the current confining layer 105 is to be formed by setting the V/III ratio, the V/III ratio shown in Fig. 3 is set to K3. Under the condition of the V/III ratio of K3, the epitaxial layer has an n-type region when grown on the (1 0 0) plane and a p-type region when grown on the (3 1 1)A plane. Therefore, the current confining layer 105 shown in Fig. 11 has a n-type region under the flat surface and a p-type region under the slanted surface.

If the current confining layer 105 is to be formed by doping both carbon and silicon at the same time, the layer 105 is grown under the conditions that the silicon concentration is set to the broken line "a1" in the upper drawing of Fig. 7. An n-type region is formed at the (1 0 0) plane because the silicon concentration is higher than the carbon concentration, and a p-type region is formed at the (3 1 1)A plane. Therefore, the current confining layer 105 shown in Fig. 11 has an n-type region under the flat surface and a p-type region under the slanted surface. Also in this case, it is preferable to select a V/III ratio which allows the carrier concentration to be set to 1 x 10¹⁸cm⁻³ in the n- and p-type regions.

On the current confining layer 105, a p-type AlₓGa₁₋ₓAs clad layer (e.g. x = 0.3) 106 is formed to a thickness of about 1.6 µm. Carbon is used as the p-type impurity dopant in the AlGaAs clad layer 106 to an impurity concentration of 1 x 10¹⁸cm⁻³.

The three layers, the AlGaAs clad layer 104, current confining layer 105 and AlGaAs clad layer 106, therefore all have a p-type region under the slanted surface of the (3 1 1)A plane. The current confining layer 105 between the AlGaAs clad layers 104 and 106, therefore, has an n-type region under the flat surface.

On the p-type AlGaAs clad layer 106, a p⁺-type GaAs contact layer 107 is formed to a thickness of about 0.5 µm. Carbon or zinc is doped as the p-type impurity in the GaAs contact layer 107 to an impurity concentration of 5 x 10¹⁸cm⁻³.

A positive electrode 108 of AuZn is formed on the GaAs contact layer 107 and a negative electrode 109 of AuSn is formed on the bottom surface of the GaAs substrate 100. When a voltage is applied between the positive and negative electrodes 108 and 109 the p-n junction between the current confining layer 105 and the clad layer 104 is reverse biased. Therefore, current will not flow in the region under the flat surface, but is concentrated upon the region under the slanted surface. It is therefore possible efficiently to generate laser action in the region of the active layer 103 under the slanted surface. (0 1 -1) planes or (0 -1 1) planes obtained by cleaving the wafer are used for forming the end mirrors of the laser resonator (cavity).

In Fig. 11, the (3 1 1)A plane is used for the slanted region. Another plane in the range from the (1 1 1)A plane to the (3 1 1)A plane having a carbon capture cross-section larger than that of the (1 0 0) plane may also be used.

Fig. 12 is a cross-sectional view of a semiconductor laser according to a second embodiment of the invention. The semiconductor laser of the second embodiment is formed by utilizing the difference in impurity capture cross-section between planes oriented in the range from a (5 1 1)A plane to a (4 1 1)A plane on the one hand and a (3 1 1)A plane on the other hand. On the surface of an n⁺-type GaAs substrate 120 having the plane in the range from the (5 1 1)A plane to the (4 1 1)A plane on its main surface, a step 130 is formed having a slanted surface of generally the (3 1 1)A plane and extending in the [0 1 -1] direction.

Similar to the semiconductor laser shown in Fig. 11, on the n⁺-type GaAs substrate 120, an n⁺-type GaAs buffer layer 121, an n-type AlGaAs clad layer 122, an undoped GaAs or AlGaAs active layer or a GaAs/InGaAs/GaAs strained quantum well active layer 123, a p-type AlGaAs clad layer 124, a current confining layer 125, a p-type AlGaAs clad layer 126, and a p⁺-type GaAs contact layer 127 are formed.

A positive electrode 128 of AuZn is formed on the p⁺-type GaAs contact layer 127 and a negative electrode 129 of AuSn is formed on the bottom surface of the n⁺-type GaAs substrate 120.

The current confining layer 125 is epitaxially grown by doping both carbon and silicon at the same time under the conditions that an n-type region is formed at the plane in the range from the (4 1 1)A plane to the (5 1 1)A plane and a p-type region is formed at the (3 1 1)A plane as indicated by the broken line "a" or "a1" in the upper diagram of Fig. 7. With the epitaxial growth of the current confining layer 125 under such conditions, the current confining layer 125 of this embodiment has an n-type region under the flat surface and a p-type region under the slanted surface, like the first embodiment shown in Fig. 11.

In Fig. 12, a plane oriented in the range from the (4 1 1)A plane to the (5 1 1)A plane is used as the main surface of the substrate and a (3 1 1)A plane is used as the slanted surface of the substrate. A (n 1 1)A plane, where n is a real number of about 4 ≤ n, may be used as the main surface of a substrate, and a plane in the range from a (1 1 1)A plane to a (3 1 1)A plane may be used as the slanted surface.

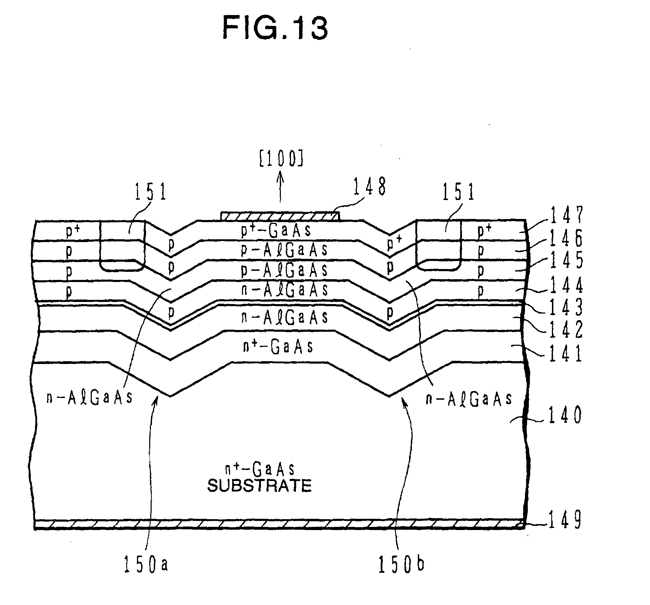

Fig. 13 is a cross-sectional view of a semiconductor laser according to a third embodiment of the invention. The semiconductor laser of the third embodiment is formed by utilizing the difference in impurity capture cross-section between (1 0 0) planes on the one hand and (4 1 1)A plane or (4 1 1)B planes on the other hand. On the surface of an n⁺-type GaAs substrate 140 having the (1 0 0) plane on its main surface, grooves 150a and 150b of a V-shape spaced apart by a predetermined distance are formed, having a slanted surface of generally the (4 1 1)A plane and extending in the [0 1 -1] direction. Alternatively, a substrate may be used which has grooves of a V-shape spaced apart by a predetermined distance, the grooves having a slanted surface of generally the (4 1 1)B plane and extending in the [0 1 1] direction.

Similar to the semiconductor laser shown in Fig. 11, on the n⁺-type GaAs substrate 140, an n⁺-type GaAs buffer layer 141, an n-type AlGaAs clad layer 142, an undoped GaAs or AlGaAs active layer or a GaAs/InGaAs/GaAs strained quantum well active layer 143, a p-type AlGaAs clad layer 144, a current confining layer 145, a p-type AlGaAs clad layer 146, and a p⁺-type GaAs contact layer 147 are formed.

A positive electrode 148 of AuZn is formed on the p⁺-type GaAs contact layer 147 and a negative electrode 149 of AuSn is formed on the bottom surface of the n⁺-type GaAs substrate 140.

Near the boundaries between the regions under the outside slanted surfaces of the two grooves 150a and 150b and the regions under the outside flat surfaces, high resistance regions 151 are formed by ion implantation from the surface of the p⁺-type GaAs contact layer 147 to the middle level of the current confining layer 145. These high resistance regions 151 serve to electrically isolate the device from adjacent devices.

The current confining layer 145 is epitaxially grown by doping both carbon and silicon at the same time under the conditions that an n-type region is formed at the (4 1 1)A plane or the (4 1 1)B plane and a p-type region is formed at the (1 0 0) plane as indicated by the broken line "a" in the upper drawing or Fig. 7. With the epitaxial growth of the current confining layer 145 under such conditions, the current confining layer 145 of this embodiment has an n-type region under the slanted surface and a p-type region under the flat surface, opposite to the embodiments shown in Figs. 11 and 12.

Upon application of a voltage between the electrodes 148 and 149, the p-n junction at the region under the slanted surface is reverse biased. Therefore, current flows through and concentrates upon the region under the flat surface.

In Fig. 13, although the (4 1 1)A plane or the (4 1 1)B plane is used as the slanted surface of a substrate, a (n 1 1)A plane or a (n 1 1)B plane, where n is a real number of about 4 ≤ n, may be used which has a carbon capture cross-section smaller than the (1 0 0) plane.

As described above, the first to third embodiments can epitaxially grow a current confining layer in a self-aligned manner by selecting an appropriate V/III ratio or by doping carbon and silicon at the same time at an appropriate crystal orientation. As exemplified by Fig. 9, group VI elements, such as sulphur and selenium, may be used instead of silicon.

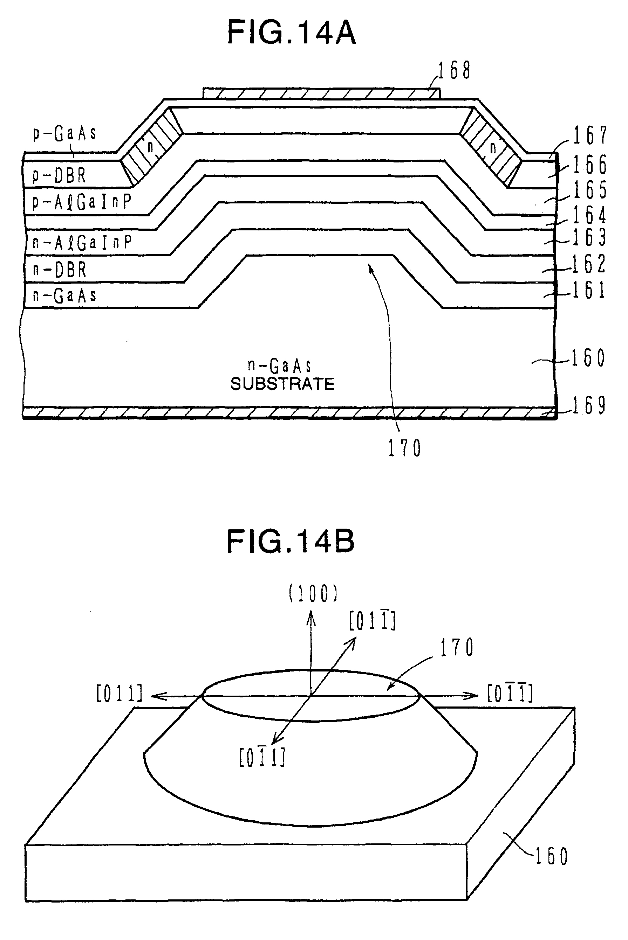

Next, a fourth embodiment will be described with reference to Figs. 14A and 14B.

Fig. 14A is a cross-sectional view of a surface emission type semiconductor laser (vertical emitter) according to the fourth embodiment of the invention. An n-type GaAs substrate having a (1 0 0) plane on its main surface is doped with silicon as the n-type impurity to an impurity concentration of 4 x 10¹⁸cm⁻³. On the surface of the GaAs substrate 160, a mesa 170 is formed having a slanted surface tilted by 15 to 35° from the main surface of the substrate.

Fig. 14B is a perspective view of the mesa 170 formed on the surface of the GaAs substrate 160. The slanted surface of the mesa 170 is curved and thus includes components of both "A" and "B" terminations. As shown in the upper diagram in Fig.7, if an epitaxial growth is performed under the silicon and carbon doping conditions indicated by the broken line "a", the region under the B planes becomes n-type in the range from 15 to 35° and the region under the A planes becomes n-type in the range from 15 to 20°. Accordingly, if the slanted surface is formed at the A or B planes in these angular ranges, an epitaxial layer can be formed having a p-type region under the flat surface and an n-type region under at least a part of the slanted surface, by doping both carbon and silicon at the same time. As will be appreciated, if the slant angle is in the overlapping portion of the two above-mentioned angular ranges, i.e. between 15 and 20°, an n-type region will be formed around the whole of the slanted surface.

On the GaAs substrate 160, an n-type GaAs buffer layer 161 is formed to a thickness of 1.0 µm. Silicon is doped as the n-type impurity to an impurity concentration of 1 x 10¹⁸cm⁻³.

On the n-type GaAs buffer Layer 161, an n-type distributed Bragg reflection (DBR) layer 162 of a thin film multi-layer type is formed, the layer 162 being made of a combination of layers such as
AlₓGa₁₋ₓAs/Al_{y}Ga_{1-y}As.

On the n-type DBR layer 162, a Si-doped n-type (Al_{0.7}Ga_{0.3})_{0.5}In_{0.5}P clad layer 163 is formed.

On the n-type AlGaInP clad layer 163, a laser structure 164 is formed. The laser structure 164 has a strained quantum well active layer made of an undoped (AlₓGa₁₋ₓ)_{0.5}In_{0.5}P well layer (e.g. x ≤ 0.1) or a (GaₓIn₁₋ₓ)(As_{y}P_{1-y}) well layer (e.g. x = 0.4, y = 0.1) and an (Al_{0.4}Ga_{0.6})_{0.5}In_{0.5}P barrier layer, and n- and p-type (Al_{0.4}Ga_{0.6})_{0.5}In_{0.5}P guide layers sandwiching the active layer.

On the laser structure 164, a Zn-doped p-type (Al_{0.7}Ga_{0.3})_{0.5}In_{0.5}P clad layer 165 is formed. The cladding layer 165 may be formed with selective doping so that it is p-type over the (100) surfaces but n-type over the slanted surfaces of the mesa structure, or at least a part of the slanted surfaces. On the p-type AlGaInP clad layer 165, a p-type AlₓGa₁₋ₓAs/Al_{y}Ga_{1-y}As DBR layer 166 is formed. On the p-type DBR layer 166, a C- or Zn-doped p-type GaAs contact layer 167 is formed. A positive electrode 168 of AuZn is formed on the region under the flat surface of the p-type GaAs contact layer and a negative electrode 169 of AuSn is formed on the bottom surface of the n-type GaAs substrate 160.

The conductivity type of the region under the flat surface of the DBR layer can be made p-type and that of the region under the slanted surface thereof can be made n-type, by selecting an appropriate V/III ratio (Fig. 3), if a group III source material containing carbon is used, or by adjusting the doping concentration of carbon (Fig. 1), if a carbon source material only is used. Alternatively, by adjusting the doping concentrations of carbon and silicon, and doping them at the same time (Fig. 7), the conductivity types of the regions under the flat surface and the slanted surface can also be made p-type and n-type respectively.

The above-described structure is for a surface or vertical emission type laser having an oscillation wavelength in the 0.6 µm band. A surface emission type laser having an oscillation wavelength in the 0.78 to 0.98 µm band may also be formed, by replacing the n-type AlGaInP clad layer 163 by an n-type AlₓGa₁₋ₓAs (e.g. x = 0.3) layer, the laser structure 164 by a laser structure made of a GaAs barrier layer and an InₓGa₁₋ₓAs (e.g. x = 0.2) strained active layer, and the p-type AlGaInP clad layer 165 by a C-doped p-type AlₓGa₁₋ₓAs (e.g. x = 0.3) clad layer. In this case, similar to the above-described method, the current confining layer can be formed in a self-aligned manner when the p-type AlGaAs clad layer and p-type DBR layer are formed.

In the above manner, the n-type region surrounding the p-type region under the flat surface can be formed in a self-aligned manner. By applying a voltage between the electrodes 168 and 169, current from the p-type GaAs contact layer passes through the central p-type part of the DBR layer 166 and is injected into the laser structure 164. The peripheral area of this current path is formed with a p-n-p junction and one of the p-n junctions is reverse biased. Therefore, current can flow through and be concentrated upon the region of the laser structure 164 under the flat surface.

## Claims

1. A method of manufacturing a semiconductor device, the method comprising the steps of:
preparing a substrate, made of a group III-V compound semiconductor containing arsenic as a group V element, to have a stepped surface containing first and second planes of different respective crystal orientations, said first and second planes having different carbon capture cross-sections in respect of at least one epitaxial layer to be formed on the surface of said stepped substrate using carbon as a dopant impurity; and
epitaxially growing at least one group III-V compound semiconductor layer, containing arsenic as a group V element, on said stepped substrate using metal organic vapour phase epitaxy (MOVPE) while doping with carbon as a dopant impurity under such conditions that the or each epitaxial layer thus grown has different conductivity types on said first and second planes, said epitaxial growth step involving epitaxially growing said group III-V compound semiconductor using an organic metal compound containing carbon as a group III source material while controlling the partial pressure ratio between the group III source material and a group V source material so as to make the or each epitaxial layer thus grown p-type on one of said first and second planes and n-type on the other of said first and second planes.

2. A method according to claim 1, wherein:
said first plane is a (1 0 0) plane and said second plane is a (n 1 1)B plane, where n is a real number of about 1 ≤ n, or a (m 1 1)A plane, where m is a real number of about 4 ≤ m; and
said epitaxial growth step involves epitaxially growing the group III-V compound semiconductor layer(s) on said stepped substrate while doping with carbon as a dopant impurity under such conditions that the or each epitaxial layer thus grown is n-type where grown on said second plane and p-type where grown on said first plane.

3. A method according to claim 1, wherein:
said first plane is a (1 0 0) plane and said second plane is a (n 1 1)A plane, where n is a real number of about 1 ≤ n ≤ about 3; and
said epitaxial growth step involves epitaxially growing the group III-V compound semiconductor layer(s) on said stepped substrate while doping with carbon as a dopant impurity under such conditions that the or each epitaxial layer thus grown is p-type where grown on said second plane and n-type where grown on said first plane.

4. A method according to claim 1, wherein:
said first plane is a (n 1 1)A plane, where n is a real number of about 4 ≤ n, and said second plane is a (m 1 1)A plane, where m is a real number of about 1 ≤ m ≤ about 3; and
said epitaxial growth step involves epitaxially growing the group III-V compound semiconductor layer(s) on said stepped substrate while doping with carbon as a dopant impurity under such conditions that the or each epitaxial layer thus grown is p-type where grown on said second plane and n-type where grown on said first plane.

5. A method according to claim 1, wherein:
the stepped surface has a mesa structure, said first plane forming an upper plateau surface of the mesa structure and having a (1 0 0) plane, and said second plane forming slanted side surfaces of the mesa structure; and
said epitaxial growth step involves epitaxially growing the group III-V compound semiconductor layer(s) on said stepped substrate while doping with carbon as a dopant impurity under such conditions that the or each epitaxial layer thus grown is p-type where grown on said second plane and n-type where grown on said first plane.

6. A method of manufacturing a semiconductor device, the method comprising the steps of:
preparing a substrate, made of a group III-V compound semiconductor containing arsenic as a group V element, to have a stepped surface containing first and second planes of different respective crystal orientations, said first and second planes having different carbon capture cross-sections in respect of at least one epitaxial layer to be formed on the surface of said stepped substrate using carbon as a dopant impurity; and
epitaxially growing at least one group III-V compound semiconductor layer, containing arsenic as a group V element, on said stepped substrate using metal organic vapour phase epitaxy (MOVPE) while doping with at least carbon as a dopant impurity, said carbon being a p-type dopant for both said first and second planes and having a first concentration when situated over one of said first and second planes, and a second, different concentration when situated over the other of said first and second planes, and doping at the same time or in a different doping step, with a further dopant impurity, said further dopant impurity being an n-type dopant for both said first and second planes and having a third concentration between said first and second concentrations, said third concentration being high enough to compensate the lower of said first and second concentrations, but not high enough to compensate the higher of said first and second concentrations, such that the or each epitaxial layer thus grown has different conductivity types on said first and second planes, said epitaxial growth step involving epitaxially growing said group III-V compound semiconductor using an organic metal compound containing carbon as a group III source material while controlling the partial pressure ratio between the group III source material and a group V source material so as to make the or each epitaxial layer thus grown p-type on one of said first and second planes and n-type on the other of said first and second planes.

7. A method according to claim 6, wherein:
said first plane is a (1 0 0) plane and said second plane is a (n 1 1)B plane, where n is a real number of about 1 ≤ n; and
said epitaxial growth step involves epitaxially growing the group III-V compound semiconductor layer(s) under such conditions that the or each epitaxial layer thus grown is n-type where grown on said second plane and p-type where grown on said first plane.

8. A method according to claim 6, wherein:
said first plane is a (1 0 0) plane and said second plane is an (n 1 1)A plane, where n is a real number of about 4 ≤ n; and
said epitaxial growth step involves epitaxially growing the group III-V compound semiconductor layer(s) under such conditions that the or each epitaxial layer grown is n-type where grown on said second plane and p-type where grown on said first plane.

9. A method according to claim 6, wherein:
said first plane is a (1 0 0) plane or an (n 1 1)A plane, where n is a real number of about 4 ≤ n, and said second plane is a (m 1 1)A plane, where m is a real number of about 1 ≤ m ≤ about 3; and
said epitaxial growth step involves epitaxially growing the group III-V compound semiconductor layer(s) under such conditions that the or each epitaxial layer grown is p-type where grown on said second plane and n-type where grown on said first plane.

10. A method according to claim 6, wherein:
the stepped surface has a mesa structure, said first plane forming an upper plateau surface of the mesa structure and having a (1 0 0) plane, and said second plane forming slanted side surfaces of the mesa structure; and
said epitaxial growth step involves epitaxially growing the group III-V compound semiconductor layer(s) under such conditions that the or each epitaxial layer grown is n-type where grown on said second plane and p-type where grown on said first plane.

11. A method according to claim 6, wherein said epitaxial growth step involves epitaxially growing the group III-V compound semiconductor layer(s) while controlling the supply of a source material of the carbon dopant and the supply of a source material of said further dopant impurity so as to make the or each epitaxial layer thus grown p-type on one of said first and second planes and n-type on the other of said first and second planes.

12. A method according to any one of claims 6 to 11, wherein said further dopant impurity is silicon.

13. A method according to any one of claims 6 to 11, wherein said further dopant impurity is a group VI element.

14. A method according to claim 13, wherein said further dopant impurity is sulphur or selenium.

15. A method according to any preceding claim, wherein the group III-V compound semiconductor of the substrate and of said epitaxial layer comprises gallium as a group III element.

16. A method according to claim 15, wherein the group III-V compound semiconductor of the substrate and of said epitaxial layer comprises aluminium as a further group III element.

17. A semiconductor device comprising:
a substrate made of a group III-V compound semiconductor, containing arsenic as a group V element, and having a stepped surface containing first and second planes of different respective crystal orientations; and
at least one epitaxial layer of a group III-V compound semiconductor, containing arsenic as a group V element, arranged on the stepped surface,
**characterised in that**
the or each epitaxial layer contains carbon as a dopant impurity, the carbon in the or each epitaxial layer being incorporated as an n-type dopant impurity where situated over one of said first and second planes of the substrate and as a p-type dopant impurity where situated over the other of said first and second planes, so that the or each epitaxial layer has regions of opposite conductivity type across its lateral extent.

18. A semiconductor device comprising:
a substrate made of a group III-V compound semiconductor, containing arsenic as a group V element, and having a stepped surface containing first and second planes of different respective crystal orientations; and
at least one epitaxial layer of a group III-V compound semiconductor, containing arsenic as a group V element, arranged on the stepped surface,
**characterised in that**
the or each epitaxial layer contains carbon as a p-type dopant impurity and a further element as an n-type dopant impurity,
the carbon in the or each epitaxial layer being present at a first concentration where situated over one of said first and second planes of the substrate and a second concentration, different from the first concentration, where situated over the other of said first and second planes, and the further element in the or each epitaxial layer being present at a third concentration, between the first and second concentrations, where situated over both the first and second planes, said third concentration being high enough to compensate the lower of said first and second concentrations, but not high enough to compensate the higher of said first and second concentrations so that the or each epitaxial layer has regions of opposite conductivity type across its lateral extent.

19. A semiconductor device according to claim 18, wherein said further dopant is a group VI element.

20. A semiconductor device according to claim 19, wherein said further dopant is sulphur or selenium.

21. A semiconductor device according to any one of claims 17 to 20, the semiconductor device being a laser structure and the stepped surface containing a region oriented with said first plane and two regions oriented with said second plane and spanning said first-mentioned region, the stepped surface having built up thereon a first cladding layer of a first conductivity type, an active layer formed on said first cladding layer, and a second cladding layer formed on said active layer, wherein the second cladding layer includes as a layer thereof the, or one of said, epitaxial layers, which epitaxial layer serves as a current confining layer in the laser, which current confining layer has a region of a second conductivity type, opposite to said first conductivity type, at the said first plane and a region of said first conductivity type at said second plane.

22. A semiconductor device according to claim 21, wherein:
the stepped surface has a V groove (110) with said second plane forming a main surface of the stepped surface and having a (1 0 0) plane, and the first plane forming both slanted surfaces of the V groove and having a (n 1 1)A plane, where n is a real number of about 1 ≤ n ≤ about 3; and wherein
said current confining layer (105) is n-type where situated over said second plane and p-type where situated over said first plane.

23. A semiconductor device according to claim 21, wherein:
said second plane forms two levels of a main surface of said stepped surface and has a (n 1 1)A plane, where n is a real number of 4 ≤ n;
said first plane forms a slanted surface interconnecting said two levels of main surface and having a (m 1 1)A plane, where m is a real number of about 1 ≤ m ≤ about 3; and
said current confining layer (125) is n-type where situated over said second plane and p-type where situated over said first plane.

24. A semiconductor device according to claim 21, wherein:
two parallel V grooves are formed on the stepped surface;
said first plane forms a flat surface between said two V grooves (150a, 150b) and has a (1 0 0) plane;
said second plane forms each of the slanted surfaces of said two V grooves and has a (n 1 1)A plane, where n is a real number of about 4 ≤ n, or a (m 1 1) B plane, where m is a real number of about 4 ≤ m; and
said current confining layer (145) is p-type where situated over said first plane and n-type where situated over said second plane.

25. A semiconductor device according to any one of claims 17 to 20, the semiconductor device being a laser structure, wherein the stepped surface of the substrate has a mesa structure (170) formed by an upper surface with a (1 0 0) planar orientation and a slanted surface, surrounding the upper surface;
an n-type distributed Bragg reflector layer (162) formed on the mesa structure (170);
a first cladding layer (163) which is n-type and formed on said n-type distributed Bragg reflector layer (162);
an active layer (164) formed on said n-type cladding layer (163);
a second cladding layer (165) formed on said active layer (164) and which is p-type at least over the upper surface of the mesa structure;
a p-type distributed Bragg reflector layer (166) formed on said second cladding layer (165) and which is p-type over said upper surface and n-type over said slanted surface, said Bragg reflector layer (166) thus comprising the, or one of said, epitaxial layers.

26. A semiconductor device according to claim 25, wherein the second cladding layer (165) is n-type over at least part of said slanted surface, thus comprising another of said at least one epitaxial layers.

27. A semiconductor device according to any one of claims 17 to 26, wherein the group III-V compound semiconductor of the substrate and of the or each said epitaxial layer comprises gallium as a group III element.

28. A semiconductor device according to claim 27, wherein the group III-V compound semiconductor of the substrate and of the or each said epitaxial layer comprises aluminium as a further group III element.

## Patentansprüche

1. Verfahren zum Herstellen einer Halbleitervorrichtung, welches Verfahren die folgenden Schritte aufweist:
Präparieren eines Substrats aus einem Verbindungshalbleiter der Gruppe-III-V, welcher Arsen als Gruppe-V-Element enthält, so dass es eine gestufte Oberfläche aufweist, die erste und zweite Ebenen verschiedener jeweiliger Kristallorientierungen enthält, welche erste und zweite Ebenen verschiedene Kohlenstoffeinfangquerschnitte bezüglich zumindest einer Epitaxialschicht aufweisen, die auf der Oberfläche des gestuften Substrats unter Verwendung von Kohlenstoff als Dotierstoffverunreinigung gebildet werden soll; und
Epitaxiales Wachsen zumindest einer Gruppe-III-V-Verbindungshalbleiterschicht, die als ein Gruppe-V-Element Arsen enthält, auf dem gestuften Substrat unter Verwendung einer metallorganischen Dampfphasenepitaxie (MOVPE), während mit Kohlenstoff als Dotierstoffverunreinigung unter solchen Bedingungen dotiert wird, dass die oder jede so gewachsene Epitaxialschicht verschiedene Leitfähigkeitstypen auf der ersten und zweiten Ebene aufweist, welcher Epitaxialwachstumsschritt mit einem epitaxialen Wachsen des Gruppe-III-V-Verbindungshalbleiters unter Verwendung einer organischen Metallverbindung verbunden ist, die Kohlenstoff als ein Gruppe-III-Quellenmaterial enthält, während das Partialdruckverhältnis zwischen dem Gruppe-III-Quellenmaterial und einem Gruppe-V-Quellenmaterial so gesteuert wird, um die oder jede so gewachsene Epitaxialschicht auf einer der ersten und zweiten Ebenen zum p-Typ und auf der anderen der ersten und zweiten Ebenen zum n-Typ zu machen.

2. Verfahren nach Anspruch 1, worin:
die erste Ebene eine (1 0 0)-Ebene ist und die zweite Ebene eine (n 1 1)B-Ebene ist, wo n eine reelle Zahl von etwa 1 ≤ n ist, oder eine (m 1 1)A-Ebene ist, wo m eine reelle Zahl von etwa 4 ≤ m ist; und
der Epitaxialwachstumsschritt mit einem epitaxialen Wachsen der Schicht(en) eines Gruppe-III-V-Verbindungshalbleiters auf dem gestuften Substrat verbunden ist, während mit Kohlenstoff als Dotierstoffverunreinigung unter derartigen Bedingungen dotiert wird, dass die oder jede so gewachsene Epitaxialschicht ein n-Typ ist, wo sie auf der zweiten Ebene gewachsen ist, und ein p-Typ, wo sie auf der ersten Ebene gewachsen ist.

3. Verfahren nach Anspruch 1, worin:
die erste Ebene eine (1 0 0)-Ebene ist und die zweite Ebene eine (n 1 1)A-Ebene ist, wo n eine reelle Zahl von etwa 1 ≤ n ≤ etwa 3 ist; und
der Epitaxialwachstumsschritt mit einem epitaxialen Wachsen der Schicht(en) eines Gruppe-III-V-Verbindungshalbleiters auf dem gestuften Substrat verbunden ist, während mit Kohlenstoff als Dotierstoffverunreinigung unter derartigen Bedingungen dotiert wird, dass die oder jede so gewachsene Epitaxialschicht ein p-Typ ist, wo sie auf der zweiten Ebene gewachsen ist, und ein n-Typ, wo sie auf der ersten Ebene gewachsen ist.

4. Verfahren nach Anspruch 1, worin;
die erste Ebene eine (n 1 1)A-Ebene ist, wo n eine reelle Zahl von etwa 4 ≤ n ist, und die zweite Ebene eine (m 1 1)A-Ebene ist, wo m eine reelle Zahl von etwa 1 ≤ m ≤ etwa 3 ist; und
der Epitaxialwachstumsschritt mit einem epitaxialen Wachsen der Schicht(en) eines Gruppe-III-V-Verbindungshalbleiters auf dem gestuften Substrat verbunden ist, während mit Kohlenstoff als Dotierstoffverunreinigung unter derartigen Bedingungen dotiert wird, dass die oder jede so gewachsene Epitaxialschicht ein p-Typ ist, wo sie auf der zweiten Ebene gewachsen ist, und ein n-Typ, wo sie auf der ersten Ebene gewachsen ist.

5. Verfahren nach Anspruch 1, worin:
die gestufte Oberfläche eine Mesastruktur hat, wobei die erste Ebene eine obere Plateaufläche der Mesastruktur bildet und eine (1 0 0)-Ebene aufweist und die zweite Ebene schräge Seitenflächen der Mesastruktur bildet; und
der Epitaxialwachstumsschritt mit einem epitaxialen Wachsen der Schicht(en) eines Gruppe-III-V-Verbindungshalbleiters auf dem gestuften Substrat verbunden ist, während mit Kohlenstoff als Dotierstoffverunreinigung unter derartigen Bedingungen dotiert wird, dass die oder jede so gewachsene Epitaxialschicht ein p-Typ ist, wo sie auf der zweiten Ebene gewachsen ist, und ein n-Typ, wo sie auf der ersten Ebene gewachsen ist.

6. Verfahren zum Herstellen von Halbleitervorrichtungen, welches Verfahren die folgenden Schritte aufweist:
Präparieren eines Substrats aus einem Verbindungshalbleiter der Gruppe-III-V, welcher Arsen als Gruppe-V-Element enthält, so dass es eine gestufte Oberfläche aufweist, die erste und zweite Ebenen verschiedener jeweiliger Kristallorientierungen enthält, welche erste und zweite Ebenen verschiedene Konlenstoffeinfangquerschnitte bezüglich zumindest einer Epitaxialschicht aufweisen, die auf der Oberfläche des gestuften Substrats unter Verwendung von Kohlenstoff als Dotierstoffverunreinigung gebildet werden soll; und
Epitaxiales Wachsen zumindest einer Gruppe-III-V-Verbindungshalbleiterschicht, die als ein Gruppe-V-Element Arsen enthält, auf dem gestuften Substrat unter Verwendung einer metallorganischen Dampfphasenepitaxie (MOVPE), während mit zumindest Kohlenstoff als Dotierstoffverunreinigung dotiert wird, wobei der Kohlenstoff ein p-Typ-Dotierstoff für sowohl die ersten als auch zweiten Ebenen ist und eine erste Konzentration aufweist, wenn er sich über einer der ersten und zweiten Ebenen befindet, und eine zweite verschiedene Konzentration, wenn er sich über der anderen der ersten und zweiten Ebenen befindet, und zur gleichen Zeit oder in einem verschiedenen Dotierschritt mit einer weiteren Dotierstoffverunreinigung dotiert wird, welche weitere Dotierstoffverunreinigung ein n-Typ-Dotierstoff für sowohl die ersten als auch zweiten Ebenen ist und eine dritte Konzentration zwischen der ersten und zweiten Konzentration hat, welche dritte Konzentration hoch genug ist, um die niedrigere der ersten und zweiten Konzentrationen zu kompensieren, aber nicht hoch genug, um die höhere der ersten und zweiten Konzentrationen zu kompensieren, so dass die oder jede so gewachsene Epitaxialschicht verschiedene Leitfähigkeitstypen auf den ersten und zweiten Ebenen aufweist, wobei der Epitaxialwachstumssthritt mit einem Wachsen des Gruppe-III-V-Verbindungshalbleiters unter Verwendung einer organischen Metallverbindung verbunden ist, die als ein Gruppe-III-Quellenmaterial Kohlenstoff enthält, während das Partialdruckverhältnis zwischen dem Gruppe-III-Quellenmaterial und einem Gruppe-V-Quellenmaterial so gesteuert wird, um die oder jede so gewachsene Epitaxialschicht auf einer der ersten und zweiten Ebenen zum p-Typ und auf der anderen der ersten und zweiten Ebenen n-Typ zu machen.

7. Verfahren nach Anspruch 6, worin:
die erste Ebene eine (1 0 0)-Ebene ist und die zweite Ebene eine (n 1 1)B-Ebene ist, wo n eine reelle Zahl von etwa 1 ≤ n ist; und
der Epitaxialwachstumsschritt mit einem epitaxialen Wachsen der Schicht(en) eines Gruppe-III-V-Verbindungshalbleiters unter solchen Verbindungen verbunden ist, dass die oder jede so gewachsene Epitaxialschicht ein n-Typ ist, wo sie auf der zweiten Ebene gewachsen ist, und ein p-Typ, wo sie auf der ersten Ebene gewachsen ist.

8. Verfahren nach Anspruch 6, worin:
die erste Ebene eine (1 0 0)-Ebene ist und die zweite Ebene eine (n 1 1)A-Ebene ist, wo n eine reelle Zahl von etwa 4 ≤ n ist; und
der Epitaxialwachstumsschritt mit einem epitaxialen Wachsen der Schicht(en) eines Gruppe-III-V-Verbindungshalbleiters unter solchen Verbindungen verbunden ist, dass die oder jede so gewachsene Epitaxialschicht ein n-Typ ist, wo sie auf der zweiten Ebene gewachsen ist, und ein p-Typ, wo sie auf der ersten Ebene gewachsen ist.

9. Verfahren nach Anspruch 6, worin:
die erste Ebene eine (1 0 0)-Ebene ist und oder eine (n 1 1)A-Ebene ist, wo n eine reelle Zahl von etwa 4 ≤ n ist, und die zweite Ebene eine (m 1 1)A-Ebene ist, wo m eine reelle Zahl von etwa 1 ≤ m ≤ etwa 3 ist; und
der Epitaxialwachstumsschritt mit einem epitaxialen Wachsen der Schicht(en) eines Gruppe-III-V-Verbindungshalbleiters unter solchen Bedingungen verbunden ist, dass die oder jede gewachsene Epitaxialschicht ein p-Typ ist, wo sie auf der zweiten Ebene gewachsen ist, und ein n-Typ, wo sie auf der ersten Ebene gewachsen ist.

10. Verfahren nach Anspruch 6, worin:
die gestufte Oberfläche eine Mesastruktur hat, wobei die erste Ebene eine obere Plateaufläche der Mesastruktur bildet und eine (1 0 0)-Ebene hat und die zweite Ebene schräge Seitenflächen der Mesastruktur bildet; und
der Epitaxialwachstumsschritt mit einem epitaxialen Wachsen der Schicht(en) eines Gruppe-III-V-Verbindungshalbleiters unter solchen Bedingungen verbunden ist, dass die oder jede gewachsene Epitaxialschicht ein n-Typ ist, wo sie auf der zweiten Ebene gewachsen ist, und ein p-Typ, wo sie auf der ersten Ebene gewachsen ist.

11. Verfahren nach Anspruch 6, worin der Epitaxialwachstumsschritt mit einem epitaxialen Wachsen der Schicht (en) eines Gruppe-III-V-Verbindungshalbleiters verbunden ist, während die Zufuhr eines Quellenmaterials des Kohlenstoffdotierstoffes und die Zufuhr eines Quellenmaterials der weiteren Dotierstoffverunreinigung so gesteuert werden, um die oder jede so gewachsene Epitaxialschicht auf einer der ersten und zweiten Ebenen zum p-Typ und auf der anderen der ersten und zweiten Ebenen zum n-Typ zu machen.

12. Verfahren nach einem der Ansprüche 6 bis 11, worin die weitere Dotierstoffverunreinigung Silizium ist.

13. Verfahren nach einem der Ansprüche 6 bis 11, worin die weitere Dotierstoffverunreinigung ein Gruppe-VI-Element ist.

14. Verfahren nach Anspruch 13, worin die weitere Dotierstoffverunreinigung Schwefel oder Selen ist.

15. Verfahren nach einem der vorhergehenden Ansprüche, worin der Gruppe-III-V-Verbindungshalbleiter des Substrats und der Epitaxialschicht Gallium als ein Gruppe-III-Element aufweist.

16. Verfahren nach Anspruch 15, worin in der Gruppe-III-V-Verbindungshalbleiter des Substrats und der Epitaxialschicht Aluminium als ein weiteres Gruppe-III-Element aufweist.

17. Halbleitervorrichtung, aufweisend:
ein Substrat, das aus einem Gruppe-III-V-Verbindungshalbleiter besteht, der als ein Gruppe-V-Element Arsen enthält, und eine gestufte Oberfläche aufweist, die erste und zweite Ebenen mit verschiedenen jeweiligen Kristallorientierungen aufweist; und
zumindest eine Epitaxialschicht eines als ein Gruppe-V-Element Arsen enthaltenden Gruppe-III-V-Verbindungshalbleiters, die auf der gestuften Oberfläche angeordnet ist;
**dadurch gekennzeichnet, dass**
die oder jede Epitaxialschicht Kohlenstoff als eine Dotierstoffverunreinigung enthält, welcher Kohlenstoff in der oder jeder Epitaxialschicht als Dotierstoffverunreinigung vom n-Typ eingebaut ist, wo er über einer der ersten und zweiten Ebenen des Substrats liegt, und als Dotierstoffverunreinigung vom p-Typ, wo er über der anderen der ersten und zweiten Ebenen liegt, so dass die oder jede Epitaxialschicht über ihre laterale Ausdehnung Regionen entgegengesetzten Leitfähigkeitstyps hat.

18. Halbleitervorrichtung, aufweisend:
ein Substrat, das aus einem Gruppe-III-V-Verbindungshalbleiter besteht, der als ein Gruppe-V-Element Arsen enthält, und eine gestufte Oberfläche aufweist, die erste und zweite Ebenen mit verschiedenen jeweiligen Kristallorientierungen aufweist; und
zumindest eine Epitaxialschicht eines als ein Gruppe-V-Element Arsen enthaltenden Gruppe-III-V-Verbindungshalbleiters, die auf der gestuften Oberfläche angeordnet ist;
**dadurch gekennzeichnet, dass**
die oder jede Epitaxialschicht Kohlenstoff als Dotierstoffverunreinigung vom p-Typ und ein weiteres Element als Dotierstoffverunreinigung vom n-Typ enthält,
wobei der Kohlenstoff in der oder jeder Epitaxialschicht in einer ersten Konzentration vorhanden ist, wo er über einer der ersten und zweiten Ebenen des Substrats liegt, und einer von der ersten Konzentration verschiedenen zweiten Konzentration, wo er über der anderen der ersten und zweiten Ebenen liegt, und das weitere Element in der oder jeder Epitaxialschicht in einer dritten Konzentration zwischen der ersten und zweiten Konzentration vorhanden ist, wo es über sowohl den ersten als auch zweiten Ebenen liegt, welche dritte Konzentration hoch genug ist, um die niedrigere der ersten und zweiten Konzentrationen zu kompensieren, nicht aber hoch genug, um die höhere der ersten und zweiten Konzentrationen zu kompensieren, so dass die oder jede Epitaxialschicht über ihre laterale Ausdehnung Regionen entgegengesetzten Leitfähigkeitstyps aufweist.

19. Halbleitervorrichtung nach Anspruch 18, worin der weitere Dotierstoff ein Gruppe-VI-Element ist.

20. Halbleitervorrichtung nach Anspruch 19, worin der weitere Dotierstoff Schwefel oder Selen ist.

21. Halbleitervorrichtung nach einem der Ansprüche 17 bis 20, welche Halbleitervorrichtung eine Laserstruktur ist und welche gestufte Oberfläche eine mit der ersten Ebene orientierte Region und zwei mit der zweiten Ebene orientierte und die zuerst erwähnte Region umfassende Regionen enthält, wobei die gestufte Oberfläche darauf aufgebaut eine erste Überzugsschicht eines ersten Leitfähigkeitstyps, eine auf der ersten Überzugsschicht gebildete aktive Schicht und eine auf der aktiven Schicht gebildete zweite Überzugsschicht aufweist, worin die zweite Überzugsschicht als eine Schicht davon die oder eine der Epitaxialschichten enthält, welche Epitaxialschicht als eine strombegrenzende Schicht im Laser dient, welche strombegrenzende Schicht eine Region eines zum ersten Leitfähigkeitstyp entgegengesetzten zweiten Leitfähigkeitstyps bei der ersten Ebene und eine Region des ersten Leitfähigkeitstyps bei der zweiten Ebene aufweist.

22. Halbleitervorrichtung nach Anspruch 21, worin:
die gestufte Oberfläche eine V-Rille (110) aufweist, wobei die zweite Ebene eine Hauptfläche der gestuften Oberfläche bildet und eine (1 0 0)-Ebene aufweist und die erste Ebene beide schrägen Flächen der V-Rille bildet und eine (n 1 1)A-Ebene aufweist, wo n eine reelle Zahl von etwa 1 ≤ n ≤ etwa 3 ist; und worin
die strombegrenzende Schicht (105) ein n-Typ ist, wo sie über der zweiten Ebene liegt, und ein p-Typ, wo sie über der ersten Ebene liegt.

23. Halbleitervorrichtung nach Anspruch 21, worin:
die zweite Ebene zwei Niveaus einer Hauptfläche der gestuften Oberfläche bildet und eine (n 1 1)A-Ebene hat, wo n eine reelle Zahl von 4 ≤ n ist;
die erste Ebene eine schräge Fläche bildet, die die beiden Niveaus einer Hauptfläche miteinander verbindet und eine (m 1 1)A-Ebene aufweist, wo m eine reelle Zahl von etwa 1 ≤ m ≤ etwa 3 ist; und
die strombegrenzende Schicht (125) ein n-Typ ist, wo sie über der zweiten Ebene liegt, und ein p-Typ, wo sie über der ersten Ebene liegt.

24. Halbleitervorrichtung nach Anspruch 21, worin:
zwei parallele V-Rillen auf der gestuften Oberfläche ausgebildet sind;
die erste Ebene eine flache Oberflächen zwischen den beiden V-Rillen (150a,150b) bildet und eine (1 0 0)-Ebene aufweist;
die zweite Ebene jede der schrägen Flächen der beiden V-Rillen bildet und eine (n 1 1)A-Ebene hat, wo n eine reelle Zahl von etwa 4 ≤ n ist, oder eine (m 1 1)B-Ebene, wo n eine reelle Zahl von 4 ≤ m ist; und
die strombegrenzende Schicht (145) ein p-Typ ist, wo sie über der ersten Ebene liegt, und ein n-Typ, wo sie über der zweiten Ebene liegt.

25. Halbleitervorrichtung nach einem der Ansprüche 17 bis 20, welche Halbleitervorrichtung eine Laserstruktur ist, worin die gestufte Oberfläche des Substrats eine Mesastruktur (170) aufweist, die durch eine obere Oberfläche mit einer (1 0 0)-Planarorientierung und eine schräge Oberfläche gebildet wird, die die obere Oberfläche umgibt;
eine verteilte Bragg-Reflektorschicht (162) vom n-Typ, die auf der Mesastruktur (170) gebildet ist;
eine erste Überzugsschicht (163), die ein n-Typ ist und auf der verteilten Bragg-Reflektorschicht (162) vom n-Typ gebildet ist;
auf der Überzugsschicht (163) vom n-Typ eine aktive Schicht (164) ausgebildet ist;
eine zweite Überzugsschicht (165), die auf der aktiven Schicht (164) gebildet ist und welche ein p-Typ ist, zumindest über der oberen Oberfläche der Mesastruktur;
eine verteilte Bragg-Reflektorschicht (166) vom p-Typ, die auf der zweiten Überzugsschicht (165) ausgebildet ist und ein p-Typ über der oberen Oberfläche und ein n-Typ über der schrägen Oberfläche ist, welche Bragg-Reflektorschicht (166) somit die oder eine der Epitaxialschichten aufweist.

26. Halbleitervorrichtung nach Anspruch 25, worin die zweite Überzugsschicht (165) ein n-Typ über zumindest einem Teil der schrägen Oberfläche ist, somit eine andere der zumindest einen Epitaxialschicht aufweisend.

27. Halbleitervorrichtung nach einem der Ansprüche 17 bis 26, worin der Gruppe-III-V-Verbindungshalbleiter des Substrats und der oder jeder besagten Epitaxialschicht Gallium als ein Gruppe-III-Element aufweist.

28. Halbleitervorrichtung nach Anspruch 27, worin der Gruppe-III-V-Verbindungshalbleiter des Substrats und der oder jeder besagten Epitaxialschicht Aluminium als ein weiteres Gruppe-III-Element enthält.

## Revendications

1. Procédé de fabrication d'un dispositif à semiconducteur, le procédé comprenant les étapes de :
préparation d'un substrat, réalisé en un semiconducteur composite du groupe III-V contenant de l'arsenic en tant qu'élément du groupe V de telle sorte qu'il comporte une surface étagée comprenant des premier et second plans de différentes orientations cristallines respectives, lesdits premier et second plans présentant des sections de capture de carbone différentes en relation avec au moins une couche épitaxiale destinée à être formée sur la surface dudit substrat étagé en utilisant du carbone en tant qu'impureté de dopant ; et
croissance épitaxiale d'au moins une couche semiconductrice composite du groupe III-V contenant de l'arsenic en tant qu'élément du groupe V sur ledit substrat étagé en utilisant une épitaxie d'organométallique en phase vapeur (MOVPE) tout en dopant du carbone en tant qu'impureté de dopant sous des conditions qui sont telles que la couche épitaxiale ou chaque couche épitaxiale ainsi obtenue par croissance présente des types de conductivité différents sur lesdits premier et second plans, ladite étape de croissance épitaxiale mettant en jeu la croissance épitaxiale dudit semiconducteur composite du groupe III-V en utilisant un composé d'organométallique contenant du carbone en tant que matériau de source du groupe III tout en commandant le rapport de pressions partielles entre le matériau de source du groupe III et un matériau de source du groupe V de manière à constituer la couche épitaxiale ou chaque couche épitaxiale ainsi obtenue par croissance selon le type p sur l'un desdits premier et second plans et selon le type n sur l'autre desdits premier et second plans.

2. Procédé selon la revendication 1, dans lequel :
ledit premier plan est un plan (100) et le second plan est un plan (n11)B où n est un nombre réel d'environ 1 ≤ n ou un plan (m11)A où m est un nombre réel d'environ 4 ≤ m ; et
ladite étape de croissance épitaxiale met en jeu la croissance épitaxiale de la couche ou des couches semiconductrices composites du groupe III-V sur ledit substrat étage tout en réalisant un dopage avec du carbone en tant qu'impureté de dopant sous des conditions qui sont telles que la couche épitaxiale ou chaque couche épitaxiale ainsi obtenue par croissance est de type n à l'endroit où elle est obtenue par croissance sur ledit second plan et est de type p à l'endroit où elle est obtenue par croissance sur ledit premier plan.

3. Procédé selon la revendication 1, dans lequel :
ledit premier plan est un plan (100) et le second plan est un plan (n11)A où n est un nombre réel d'environ 1 ≤ n ≤ environ 3 ; et
ladite étape de croissance épitaxiale met en jeu la croissance épitaxiate de la couche ou des couches semiconductrices composites du groupe III-V sur ledit substrat étagé tout en réalisant un dopage avec du carbone en tant qu'impureté de dopant sous des conditions qui sont telles que la couche épitaxiale ou chaque couche épitaxiale ainsi obtenue par croissance est de type p à l'endroit où elle est obtenue par croissance sur ledit second plan et est de type n à l'endroit où elle est obtenue par croissance sur ledit premier plan.

4. Procédé selon la revendication 1, dans lequel :
ledit premier plan est un plan (n11)A où n est un nombre réel d'environ 4 ≤ n et ledit second plan est un plan (m11)A où m est un nombre réel d'environ 1 ≤ m ≤ environ 3 ; et
ladite étape de croissance épitaxiale met en jeu la croissance épitaxiale de la couche ou des couches semiconductrices composites du groupe III-V sur ledit substrat étagé tout en réalisant un dopage avec du carbone en tant qu'impureté de dopant sous des conditions qui sont telles que la couche épitaxiale ou chaque couche épitaxiale ainsi obtenue par croissance est de type p à l'endroit où elle est obtenue par croissance sur ledit second plan et est de type n à l'endroit où elle est obtenue par croissance sur ledit premier plan.

5. Procédé selon la revendication 1, dans lequel :
la surface étagée présente une structure mésa, ledit premier plan formant une surface de plateau supérieure de la structure mésa et présentant un plan (100) et ledit second plan formant des surfaces latérales inclinées de la structure mésa ; et
ladite étape de croissance épitaxiale met en jeu la croissance épitaxiale de la couche ou des couches semiconductrices composites du groupe III-V sur ledit substrat étagé tout en réalisant un dopage avec du carbone en tant qu'impureté de dopant sous des conditions qui sont telles que la couche épitaxiale ou chaque couche épitaxiale ainsi obtenue par croissance est de type p à l'endroit où elle est obtenue par croissance sur ledit second plan et est de type n à l'endroit où elle est obtenue par croissance sur ledit premier plan.

6. Procédé de fabrication d'un dispositif à semiconducteur, le procédé comprenant les étapes de :
préparation d'un substrat réalisé en un semiconducteur composite du groupe III-V contenant de l'arsenic en tant qu'élément du groupe V de telle sorte qu'il comporte une surface étagée qui contient des premier et second plans de différentes orientations cristallines respectives, lesdits premier et second plans présentant des sections de capture de carbone différentes en relation avec au moins une couche épitaxiale destinée à être formée sur la surface dudit substrat étagé en utilisant du carbone en tant qu'impureté de dopant ; et
croissance épitaxiale d'au moins une couche semiconductrice composite du groupe III-V contenant de l'arsenic en tant qu'élément du groupe V sur ledit substrat étagé en utilisant une épitaxie d'organométallique en phase vapeur (MOVPE) tout en dopant à l'aide d'au moins du carbone en tant qu'impureté de dopant, ledit carbone étant un dopant de type p pour à la fois lesdits premier et second plans et présentant une première concentration lorsqu'il est situé sur l'un desdits premier et second plans et une seconde concentration différente lorsqu'il est situé sur l'autre desdits premier et second plans, et en dopant en même temps ou selon une étape de dopage différente, avec une autre impureté de dopant, ladite autre impureté de dopant étant un dopant du type n pour à la fois lesdits premier et second plans et présentant une troisième concentration entre les première et seconde concentrations, ladite troisième concentration étant suffisamment élevée pour compenser la plus faible desdites première et seconde concentrations mais pas suffisamment élevée pour compenser la plus élevée desdites première et seconde concentration de telle sorte que l'une ou chaque couche épitaxiale ainsi obtenue par croissance présente des types de conductivité différente sur lesdits premier et second plans, ladite étape de croissance épitaxiale mettant en jeu une croissance épitaxiale dudit semiconducteur composite du groupe III-V en utilisant un composé d'organométallique contenant du carbone en tant matériau de source du groupe III tout en commandant le rapport de pression partielle entre le matériau de source du groupe III et un matériau de source du groupe V de manière à faire en sorte que la couche épitaxiale ou chaque couche épitaxiale ainsi obtenue par croissance soit de type p sur l'un desdits premier et second plans et du type n sur l'autre desdits premier et second plans.

7. Procédé selon la revendication 6, dans lequel :
ledit premier plan est un plan (100) et ledit second plan est un plan (n11)A où n est un nombre réel d'environ 1 ≤ n ; et
ladite étape de croissance épitaxiale met en jeu une croissance épitaxiale de la couche ou des couches semiconductrices composites du groupe III-V sous des conditions qui sont telles que la couche épitaxiale ou chaque couche épitaxiale ainsi obtenue par croissance est du type n à l'endroit où elle est obtenue par croissance sur ledit second plan et est du type p à l'endroit où elle est obtenue par croissance sur ledit premier plan.

8. Procédé selon la revendication 6, dans lequel :
ledit premier plan est un plan (100) et ledit second plan est un plan (n11)A où n est un nombre réel d'environ 4 ≤ n ; et
ladite étape de croissance épitaxiale met en jeu la croissance épitaxiale de la couche ou des couches semiconductrices composites du groupe III-V sous des conditions qui sont telles que la couche épitaxiale ou chaque couche épitaxiale est du type n à l'endroit où elle est obtenue par croissance sur ledit second plan et du type p à l'endroit où elle est obtenue par croissance sur ledit premier plan.

9. Procédé selon la revendication 6, dans lequel :
ledit premier plan est un plan (100) ou un plan (n11)A où n est un nombre réel d'environ 4 ≤ n et ledit second plan est un plan (m11)A où m est un nombre réel d'environ 1 ≤ m ≤ environ 3 ; et
ladite étape de croissance épitaxiale met en jeu une croissance épitaxiale de la couche ou des couches semiconductrices composites du groupe III-V sous des conditions qui sont telles que la ou chaque couche épitaxiale obtenue par croissance est du type p à l'endroit où elle est obtenue par croissance sur ledit second plan et du type n à l'endroit où elle est obtenue par croissance sur ledit premier plan.

10. Procédé selon la revendication 6, dans lequel :
la surface étagée présente une structure mésa, ledit premier plan formant une surface de plateau supérieure de la structure mésa et comportant un plan (100) et ledit second plan formant des surfaces latérales inclinées de la structure mésa ; et
ladite étape de croissance épitaxiale met en jeu la croissance épitaxiale de la ou des couches semiconductrices composites du groupe III-V sous des conditions qui sont telles que la couche épitaxiale ou chaque couche épitaxiale obtenue par croissance est de type n à l'endroit où elle est obtenue par croissance sur ledit second plan et de type p à l'endroit où elle est obtenue par croissance sur ledit premier plan.

11. Procédé selon la revendication 6, dans lequel ladite étape de croissance épitaxiale met en jeu la croissance épitaxiale de la ou des couches semiconductrices composites du groupe III-V tout en commandant l'alimentation d'un matériau de source du dopant de carbone et l'alimentation d'un matériau de source de ladite autre impureté de dopant de manière à flaire en sorte que la couche ou chaque couche épitaxiale ainsi obtenue par croissance soit de type p sur l'un desdits premier et second plans et de type n sur l'autre desdits premier et second plans.

12. Procédé selon l'une quelconque des revendications 6 à 11, dans lequel ladite autre impureté de dopant est du silicium.

13. Procédé selon l'une quelconque des revendications 6 à 11, dans lequel ladite autre impureté de dopant est un élément du groupe VI.

14. Procédé selon la revendication 13, dans lequel ladite autre impureté de dopant est du soufre ou du sélénium.

15. Procédé selon l'une quelconque des revendications précédentes, dans lequel le semiconducteur composite du groupe III-V du substrat et de ladite couche épitaxiale comprend du gallium en tant qu'élément du groupe III.

16. Procédé selon la revendication 15, dans lequel le semiconducteur composite du groupe III-V du substrat et de ladite couche épitaxiale comprend de l'aluminium en tant qu'autre élément du groupe III.

17. Dispositif à semiconducteur comprenant :
un substrat réalisé en un semiconducteur composite du groupe III-V, contenant de l'arsenic en tant qu'élément du groupe V et comportant une surface étagée qui contient des premier et second plans de différentes orientations cristallines respectives ; et
au moins une couche épitaxiale d'un semiconducteur composite du groupe III-V contenant de l'arsenic en tant qu'élément du groupe V, agencé sur la surface étagée,
**caractérisé en ce que** :
la ou chaque couche épitaxiale contient du carbone en tant qu'impureté de dopant, le carbone dans la ou chaque couche épitaxiale étant incorporé en tant qu'impureté de dopant de type n à l'endroit où elle est située sur l'un desdits premier et second plans du substrat et en tant qu'impureté de dopant de type p à l'endroit où elle est située sur l'autre desdits premier et second plans de telle sorte que la ou chaque couche épitaxiale comporte des régions de types de conductivité opposés sur son étendue latérale.

18. Dispositif à semiconducteur comprenant :
un substrat réalisé en un semiconducteur composite du groupe III-V, contenant de l'arsenic en tant qu'élément du groupe V et comportant une surface étagée qui contient des premier et second plans de différentes orientations cristallines respectives ; et
au moins une couche épitaxiale d'un semiconducteur composite du groupe III-V contenant de l'arsenic en tant qu'élément du groupe V, agencé sur la surface étagée,
**caractérisé en ce que** :
la ou chaque couche épitaxiale contient du carbone en tant qu'impureté de dopant de type p et un autre élément en tant qu'impureté de dopant de type n,
le carbone dans la ou chaque couche épitaxiale étant présent à une première concentration lorsqu'il est situé sur l'un desdits premier et second plans du substrat et une seconde concentration différente de la première concentration lorsqu'il est situé sur l'autre desdits premier et second plans et l'autre élément dans la ou chaque couche épitaxiale étant présent à une troisième concentration, entre les première et seconde concentrations lorsqu'il est situé sur à la fois les premier et second plans, ladite troisième concentration étant suffisamment élevée pour compenser la plus faible desdites première et seconde concentrations mais pas suffisamment élevée pour compenser la plus élevée desdites première et seconde concentrations de telle sorte que la ou chaque couche épitaxiale comporte des régions de types de conductivité opposés sur son étendue latérale.

19. Dispositif à semiconducteur selon la revendication 18, dans lequel ledit autre dopant est un élément du groupe VI.

20. Dispositif à semiconducteur selon la revendication 19, dans lequel ledit autre dopant est du soufre ou du sélénium.

21. Dispositif à semiconducteur selon l'une quelconque des revendications 17 à 20, le dispositif à semiconducteur étant une structure de laser et la surface étagée contenant une région orientée avec ledit premier plan et deux régions orientées avec ledit second plan et englobant ladite région mentionnée en premier, la surface étagée comportant élaborée sur elle une première couche de gainage d'un premier typé de conductivité, une couche active formée sur ladite première couche de gainage et une seconde couche de gainage formée sur ladite couche active, où la seconde couche de gainage inclut en tant que sa couche la couche épitaxiale ou rune desdites couches épitaxiales, laquelle couche épitaxiale joue le rôle de couche de confinement du courant dans le laser, laquelle couche de confinement du courant comporte une région d'un second type de conductivité opposé audit premier type de conductivité au niveau dudit premier plan et une région dudit premier type de conductivité au niveau dudit second plan.

22. Dispositif à semiconducteur selon la revendication 21, dans lequel:
la surface étagée comporte une gorge en V (110) avec ledit second plan formant une surface principale de la surface étagée et comportant un plan (100) et le premier plan formant à la fois des surfaces inclinées de la gorge en V et comportant un plan (n11)A où n est un nombre réel d'environ 1 ≤ n ≤ environ 3 ; et
ladite couche de confinement de courant (105) est de type n à l'endroit où elle est située sur ledit second plan et de type p à l'endroit où elle est située sur ledit premier plan.

23. Dispositif à semiconducteur selon la revendication 21, dans lequel :
ledit second plan forme deux niveaux d'une surface principale de ladite surface étagée et comporte un plan (n11)A où n est un nombre réel défini par 4 ≤ n ;
ledit premier plan forme une surface inclinée qui interconnecte lesdits deux niveaux de surface principale et qui comporte un plan m(11)A où m est un nombre réel d'environ 1 ≤ m ≤ environ 3 ; et
ladite couche de confinement de courant (125) est de type n à l'endroit où elle est située sur ledit second plan et de type p à l'endroit où elle est située sur ledit premier plan.

24. Dispositif à semiconducteur selon la revendication 21, dans lequel :
deux gorges en V parallèles sont formées sur la surface étagée ;
ledit premier plan forme une surface plane entre lesdites deux gorges en V (150A, 150B) et comporte un plan (100) ;
ledit second plan forme chacune des surfaces inclinées desdites deux gorges en V et comporte un plan (n11)A où n est un nombre réel d'environ 4 ≤ n ou un plan m(11)B où m est un nombre réel d'environ 4 ≤ m ≤ ; et
ladite couche de confinement de courant (145) est de type p à l'endroit où elle est située sur ledit premier plan et de type n à l'endroit où elle est située sur ledit second plan.

25. Dispositif à semiconducteur selon l'une quelconque des revendications 17 à 20, le dispositif à semiconducteur étant une structure de laser, où la surface étagée du substrat présente une structure mésa (170) qui est formée par une surface supérieure avec une orientation de plan (100) et une surface inclinée, entourant la surface supérieure ;
une couche de réflecteur de Bragg distribué de type n (162) formée sur la structure mésa (170);
une première couche de gainage (163) qui est de type n et qui est formée sur ladite couche de réflecteur de Bragg distribué de type n (162) ;
une couche active (164) qui est formée sur ladite couche de gainage de typé n (163) ;
une seconde couche de gainage (165) formée sur ladite couche active (164) et qui est de type p au oins sur la surface supérieure de la structure mésa ;
une couche de réflecteur de Bragg distribué de type p (166) formée sur ladite seconde couche de gainage (165) et qui est de type p sur ladite surface supérieure et de type n sur ladite surface inclinée, ladite couche de réflecteur de Bragg (166) comprenant par conséquent la couche épitaxiale ou l'une desdites couches épitaxiales.

26. Dispositif à semiconducteur selon la revendication 25, dans lequel la seconde couche de gainage (165) est de type n sur au moins une partie de ladite surface inclinée, d'où ainsi le fait qu'elle comprend une autre desdites au moins une couches épitaxiales.

27. Dispositif à semiconducteur selon l'une quelconque des revendications 17 à 26, dans lequel le semiconducteur composite du groupe III-V du substrat et la ou chaque dite couche épitaxiale comprend du gallium en tant qu'élément du groupe III.

28. Dispositif à semiconducteur selon la revendication 27, dans lequel le semiconducteur composite du groupe III-V du substrat et de la ou de chaque dite couche épitaxiale comprend de l'aluminium en tant qu'autre élément du groupe III.
